# EUROPEAN PATENT APPLICATION

(11) **EP 1 608 003 A1**
(43) Date of publication of application: **21.12.2005**
(21) Application number: 04716345.6
(22) Date of filing: 02.03.2004
(51) Int. Cl.: H01L 21/027, G03F 1/08

(54) **MASK REPEATER AND MASK MANUFACTURING METHOD**

(30) Priority: 05.03.2003 JP 2003058373; 07.03.2003 JP 2003061896; 16.05.2003 JP 2003139564; 23.10.2003 JP 2003363460; 11.11.2003 JP 2003381130; 19.12.2003 JP 2003422894
(71) Applicant: OHMI, Tadahiro, Sendai-shi, Miyagi 980-0813 (JP)
(72) Inventor: OHMI, Tadahiro, Sendai-shi, Miyagi (JP); SUGAWA, Shigetoshi, Sendai-shi, Miyagi (JP); YANAGIDA, Kimio, Fukushima (JP); TAKEHISA, Kiwamu, Sendai-shi, Miyagi (JP)
(74) Representative: Glawe, Delfs, Moll
(86) International application number: PCT/JP2004/002548
(87) International publication number: WO 2004/079799

(57) **Abstract**

A mask repeater for transferring the pattern of a master mask onto a real mask by exposure and transferring the pattern on the real mask onto a substrate such as a semiconductor wafer. The size of the master mask is larger than that of the real mask. By using an optical system for reduction-projecting soft X-rays, a 1:1 magnification mask, which is the next generation mask, is fabricated. In a scan exposure system, the shape of a slit used for scanning is made fixed, and exposure is conducted only for the exposed region to realize oblique exposure. When the shape of the slit is a trapezoid and when the exposed region is reciprocated in the scanning direction, the number of joint exposures can be decreased.

## Description

### Technical Field

This invention relates to a method of writing a mask for use in an exposure process (i.e. a lithography process) at the time of manufacturing semiconductor devices and to a system for writing the mask. A mask to be aimed in the present invention may be, for example, an F2 mask for use in F2 lithography using as a light source a fluorine molecular laser (hereinafter referred to as an F2 laser) with a wavelength of 157nm in the vacuum ultraviolet region, an EUV mask for EUVL (Extremely Ultraviolet Lithography) using a light source with a wavelength of 13.4nm in the X-ray region, an electron-beam mask for LEEPL (Low Energy E-beam Proximity Projection Lithography), or the like. Namely, the mask according to the present invention may be generally called a mask in an exposure system that is used in the next generation lithography technology (herein called the next generation mask) or the like.

### Background Art

Presently, KrF lithography is widely utilized such that a KrF excimer laser is used as a light source to emit laser light having a wavelength of 248nm in the ultraviolet region. Further, ArF lithography that uses, as a light source, an ArF excimer laser having a wavelength of 193nm has also begun to be utilized in the mass-production process.

In an exposure system (generally called a stepper) for use in such lithography, pattern transfer (also called pattern exposure) is performed onto a wafer through a reduction-projection optical system by using a pattern member with a delineated circuit pattern. This pattern member is called a reticle in the photolithography and may be generally called a mask in the X-ray lithography or the electron-beam lithography also. Herein, the reticle and mask will be collectively referred to as a mask.

Further, the mask is written by transferring a master mask having a pattern larger than that of the mask onto a mask substrate by the use of a mask repeater. Hereinbelow, the mask formed by transferring the pattern of the master mask will be referred to as an actual mask in order to distinguish it from the master mask. When writing the actual mask from the pattern on the master mask, the conventional mask repeater employs a technique of transferring the pattern on the master mask onto the mask substrate by reducing it in size through a reduction optical system. The mask repeater of this type is described in Proceedings of the SPIE, vol. 4186, pp. 34-45 and Proceedings of the SPIE, vol. 4562, pp. 522-529, Proceedings of the SPIE, vol. 4562, 2002, pp. 38-44 (referred to as reference documents 1 and 2).

As described in the foregoing documents, the substrates of the same size are normally used for the master mask and the actual mask (hereinafter may also be referred to simply as a mask). Thus, when the substrates of the same size are used for both the master mask and the actual mask and the pattern of the master mask is formed on the actual mask in a reduced size, a plurality of master masks (e.g. four master masks) should be successively replaced and exposed onto the single actual mask. Thus, on obtaining a pattern of the single actual mask from the plurality of master masks, it is necessary to perform stitch exposure at a boundary between patterns on the actual mask each time when the master masks are changed from one to another. Reference documents 1 and 2 each disclose a technique of performing seamless exposure at the time of the stitch exposure.

Japanese Unexamined Patent Application Publication (JP-A) No. 2002-356108 (reference document 3) discloses a scanning exposure system that realizes seamless stitch exposure in a scan direction. In reference document 3, oblique exposure, i.e. stitch exposure, can be realized by changing an interval or a width between slit plates that allows illumination light to pass therethrough and by obliquely changing the quantity of illumination light at end portions. However, the stitch exposure shown in reference document 3 has a problem that it is difficult to control the width of the slit plates and further it is necessary to largely reconstruct the existing scan exposure system.

On the other hand, Japanese Unexamined Patent Application Publication (JP-A) No. 2002-529927 (reference document 4) describes an EUVL (Extremely Ultraviolet Lithography) device using extremely short wavelength ultraviolet light. However, the foregoing patent document does not point out at all a problem associated with a mask used in the EUVL.

Particularly, with respect to an F2 mask for use in the F2 lithography using as a light source a fluorine molecular laser (F2 laser) with a wavelength of 157nm, a mask for the EUVL, and the like which are hopefully expected as the next generation lithography technology, a problem takes place in that there is neither glass nor polymer that can allow such short-wavelength light to pass therethrough. As a result, any pellicle that is normally disposed on a mask cannot be used.

Specifically, when particles (very small dust) and so on are adhered to a pattern surface of a mask mounted in an exposure system, the particles are also pattern-transferred and therefore it is necessary to constantly keep the state where the mask has no particles thereon. For this reason, use is usually made of a thin film of a transparent polymer that may be called a pellicle and that is about 1 micron thick. The pellicle is disposed on the pattern-surface side of the mask with a slight distance remote from the pattern surface.

In general, when the pellicle is used in this manner, even if particles are adhered to the surface of the pellicle, a transferred pattern is focused on a wafer through a reduction-projection optical system while the surface of the pellicle is not focused on the wafer. Therefore, the transferred pattern alone is transferred onto the wafer by exposure without being affected by the particles. However, as described above, the pellicle cannot be used in the foregoing next generation mask such as the F2 mask, the mask for EUVL, or the X-ray mask. Accordingly, the mask might not be utilized due to the adhesion of the particles and, therefore, a technique for replacing the using mask will also be required.

It is an object of this invention to provide a mask repeater, a mask writing system, and a mask writing method that can reduce the number of times of stitch exposure.

It is another object of this invention to provide a mask repeater, a mask writing system, and a mask writing method that can write a next generation mask quickly and inexpensively.

It is still another object of this invention to provide a mask repeater, a mask writing system, and a mask writing method that can perform oblique exposure with a simple structure and control.

### Disclosure of the Invention

According to one aspect of this invention, there is obtained a mask repeater for writing an actual mask from a master mask, which is characterized in that the master mask and the actual mask differ in size from each other. In this case, the actual mask is preferably a mask for 1:1 exposure.

According to another aspect of this invention, the size of the master mask is larger than that of the actual mask so that it is possible to reduce the number of master masks used in stitch exposure and the number of times of stitch exposure.

According to this configuration, it is possible to easily write, as the actual mask, a next generation mask that is employed in exposure using ultraviolet light of 190nm or less or an electron beam. Further, a pellicle can be provided for the master mask.

According to still another aspect of this invention, there is obtained a mask repeater characterized in that the actual mask has a pattern transferred by applying a soft X-ray to the master mask. In this case, there is provided a reduction-projection optical system for reduction-projecting the soft X-ray and this reduction-projection optical system includes no optical lenses. Further, the actual mask may be a mask that transfers a pattern by the use of an electron beam.

Further, according to another aspect of this invention, there is obtained a mask repeater characterized in that the master mask has a shape with a scan direction and a step direction perpendicular to the scan direction, wherein the shape is longer in the scan direction than in the step direction.

According to still another aspect of this invention, there is obtained a mask repeater for writing an actual mask from a master mask, which is characterized in that the master mask and the actual mask have substantially the same size, a scan exposure system is provided as an exposure system for transferring and exposing the master mask to the actual mask and, when scanning the actual mask in a scan direction and/or a step direction, oblique exposure in the scan direction or the step direction is performed without changing a shape of a slit-shaped irradiation area.

In this case, it is preferable that control means be provided for executing a control such that while scanning the slit-shaped irradiation area over an exposure area on the mask in the scan direction, when the slit-shaped irradiation area has reached each of both ends of the exposure area, irradiation of the slit-shaped irradiation area is stopped, thereby enabling the oblique exposure in the scan direction. Further, it is preferable that when scanning in the step direction, the slit-shaped irradiation area be elongate in the scan direction and have an oblique shape with respect to the step direction.

According to another aspect of this invention, there is obtained a mask repeater characterized by comprising a mechanism that moves the slit-shaped irradiation area not only in the scan direction but also in the step direction perpendicular to the scan direction and, after moving the slit-shaped irradiation area in the step direction, moves it back in the scan direction.

### Brief Description of the Drawings

Fig. 1 is a structural diagram of a mask writing system according to an embodiment of this invention.
Fig. 2 is an explanatory diagram of a writing pattern in the mask writing system.
Fig. 3 is an explanatory diagram of a large-size master mask 1 in the mask writing system.
Fig. 4 is a structural diagram of a mask writing system according to another embodiment of this invention.
Fig. 5 is a structural diagram of a mask writing system according to still another embodiment of this invention.
Fig. 6 is a schematic diagram for explaining a method of writing a large-size master mask used in this invention.
Figs. 7 (a) and (b) are diagrams for explaining a schematic structure of an exposure system that realizes an exposure method according to another embodiment of this invention.
Fig. 8 is a diagram showing a mask writing system according to another embodiment of this invention.
Fig. 9 is a diagram showing a structure of a mask repeater according to still another embodiment of this invention.
Fig. 10 is a diagram showing a schematic structure of a mask writing system used in this invention.
Fig. 11 is a diagram showing laser light intensity distribution caused by stitch exposure on a mask.
Fig. 12 is a schematic structural diagram showing a specific example of a pattern writing system used in Fig. 10.
Fig. 13 shows a specific structure of a DMD used in Fig. 12 and, herein, shows an ultraviolet-adapted DMD drive mechanism.
Fig. 14 is a diagram showing an ultraviolet-adapted DMD drive mechanism simplifying the structure of Fig. 13.
Fig. 15 is a diagram showing one example of a pinhole plate used in the pattern writing system of Fig. 12.
Fig. 16 is a diagram for explaining a method of manufacturing the pinhole plate shown in Fig. 15.
Fig. 17 is a diagram for explaining a pattern writing system using a DMD.
Fig. 18 is a diagram for explaining a technique of realizing a gray scale by the use of the pattern writing system shown in Fig. 17.
Fig. 19 is a diagram showing a pattern writing system according to another embodiment of this invention.
Fig. 20 is a diagram showing a mask writing system according to another embodiment of this invention.
Figs. 21 (a) and (b) are diagrams for explaining oblique exposure operation using the mask writing system shown in Fig. 20.
Fig. 22 is a diagram for explaining an effect achieved by a mask writing method of this invention.
Figs. 23 (a) and (b) are diagrams showing a relationship between the shape of an opening of a slit plate and an irradiation area on a master mask.
Figs. 24 (a), (b), and (c) are diagrams for explaining slit plates according to another embodiment of this invention.
Fig. 25 is a diagram showing a mask repeater according to still another embodiment of this invention.
Fig. 26 is a diagram for explaining operation of the mask repeater shown in Fig. 25.
Figs. 27 (a), (b), and (c) are diagrams for explaining a mask writing method according to another embodiment of this invention.
Figs. 28 is a diagram for explaining in detail a pattern writing system that is usable in a master mask writing system shown in Fig. 27.
Fig. 29 is a diagram showing a pinhole plate used in the pattern writing system of Fig. 28.
Fig. 30 is a diagram showing a projected area of the pinhole plate shown in Fig. 29.
Figs. 31 (a), (b), (c), and (d) are diagrams for explaining an OPC mask.
Figs. 32 (a), (b), (c), and (d) are diagrams showing a method of writing a master mask used in Fig. 27.

### Best Mode for Carrying Out the Invention

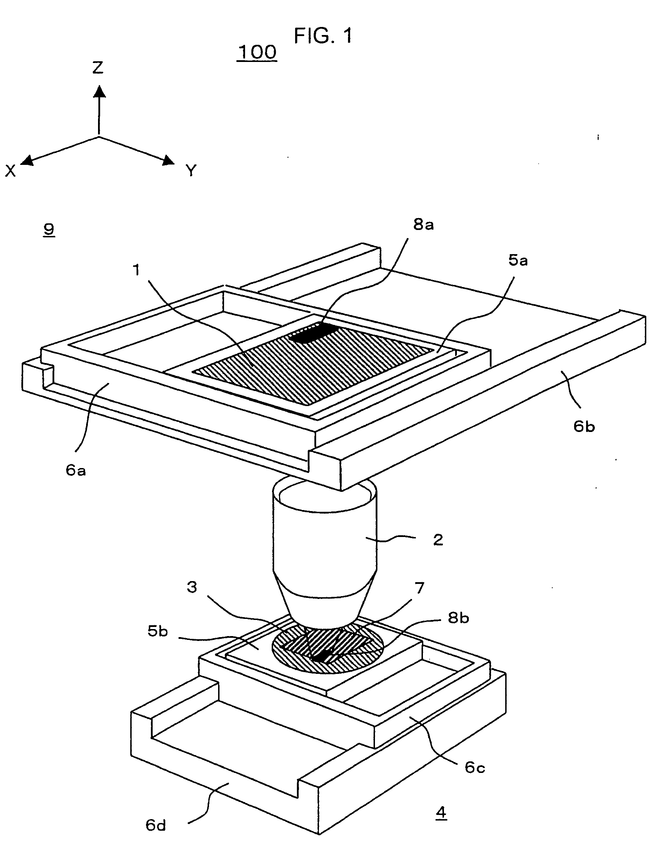

Fig. 1 is a structural diagram of a mask writing system 100 according to a first embodiment of this invention. The mask writing system 100 is a system for writing a normal 6-inch mask (a writing area of 100mm long and 132mm wide) for use as an F2 mask, an EUV mask, or the like. Therefore, the minimum line width of an objective mask has a minimum line width as well as 65nm that may be equivalent to the minimum line width which will allegedly start to be used in the F2 lithography or the EUVL.

A large-size master mask (may also be called a large-size mother mask) 1 used in the mask writing system 100 of this embodiment is four times larger than the objective mask and has a pattern writing area of 400mm in X-direction and 528mm in Y-direction. The large-size master mask 1 is placed on a stage pedestal 5a of a large-size mask stage 9. The stage pedestal 5a of the large-size mask stage 9 is reciprocatingly movable in Y-direction within a Y-stage guide 6a while the Y-stage guide 6a itself is reciprocatingly movable in X-direction within an X-stage guide 6b. Therefore, the large-size master mask 1 is movable in both X- and Y-directions (i.e. two-dimensionally).

Laser light passing through a laser light irradiation area 8a in the large-size master mask 1 passes through a reduction-projection optical system 2 to hit an exposure area 8b in a mask substrate 3. That is, a pattern within the laser light irradiation area 8a in the large-size master mask 1 is pattern-exposed to the exposure area 8b in the mask substrate 3 through the reduction-projection optical system 2. Herein, as the reduction-projection optical system 2, use is made of a 1/4 reduction-projection optical system that is employed in an ArF exposure system for semiconductor device exposure.

On the other hand, the mask substrate 3 is placed on a stage pedestal 5b. The stage pedestal 5b is movable in Y-direction within a Y-stage guide 6c while the Y-stage guide 6c itself is movable in X-direction within an X-stage guide 6d. Therefore, the mask substrate 3 is movable in both X- and Y-directions (i.e. two-dimensionally).

Thus, by cooperatively moving both the large-size master mask 1 and the mask substrate 3 in X- and Y-directions, respectively, the whole pattern of the large-size master mask 1 is transferred onto the mask substrate 3 to form a writing pattern 7. In other words, it is not necessary to replace or exchange the large-size master mask 1 until the whole writing pattern 7 is transferred onto the mask substrate 3. This shows that the large-size master mask 1 and the mask substrate 3 are in a one-to-one correspondence during the reduction-projection exposure in the writing method according to this invention.

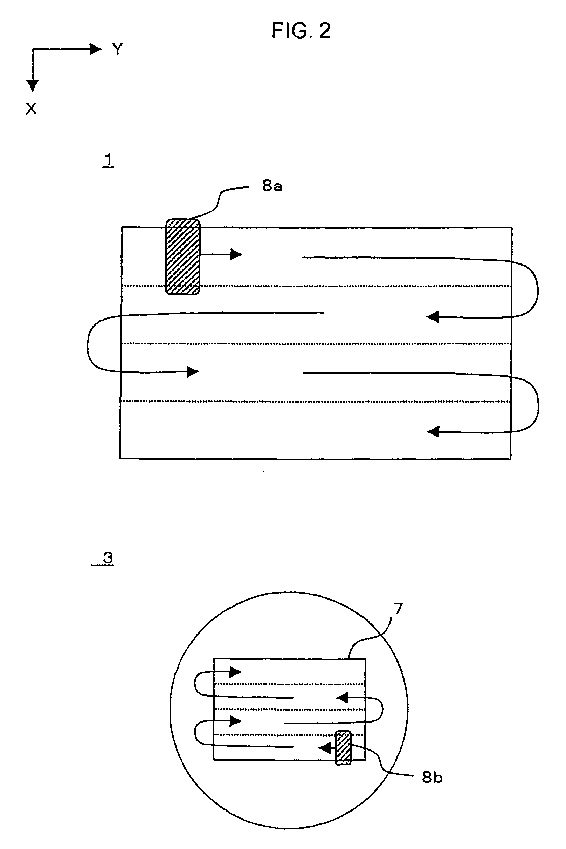

Herein, referring to Fig. 2, description will be made about the writing pattern 7 on the mask substrate 3 by the use of the large-size master mask 1. The laser light irradiation area 8a of the large-size master mask 1 is pattern-exposed one at a time through the reduction-projection optical system 2. This laser light irradiation area 8a is far smaller than the large-size master mask 1 and is herein 100mm in X-direction and 30mm in Y-direction. Therefore, the laser light irradiation area 8a is scanned in Y-direction and, at every occurrence of the reverse, is stepped in X-direction, thereby moving over the whole of the large-size master mask 1. Although not shown in the figure, an ArF excimer laser is used as an exposure light source and laser light with a wavelength of 193nm is irradiated to the laser light irradiation area 8a therefrom.

On the other hand, the exposure area 8b in the mask substrate 3 moves opposite to the laser light irradiation area 8a in the large-size master mask 1 both in X- and Y-directions. By the movement of the laser light irradiation area 8a over the whole of the large-size master mask 1, the exposure area 8b forms the writing pattern 7. Since the large-size master mask 1 is reduced in size to 1/4, the exposure area 8b has a size of 25mm in X-direction and a size of 7.5mm in Y-direction. Therefore, by the movement thereof in X- and Y-directions, the writing pattern 7 has a size of 100mm in X-direction and 132mm in Y-direction so that a quadruple photomask is written.

As described above, since the large-size master mask 1 is equal to four times the pattern size of the writing pattern 7, the minimum line width is 260nm. Therefore, on writing the large-size master mask 1, an electron-beam writing system may be used. However, it is also possible to write it with sufficient accuracy by the use of an exposure system using a KrF excimer laser with a wavelength of 248nm as a light source.

A laser-beam writing system can be used and, further, use can also be made of a laser-beam writing system using as a light source a semiconductor laser with a wavelength of 405nm longer than 248nm. This is because the resolution limit is said to be about 1/3 of a wavelength of exposure laser light and, in the case of the minimum line width being 260nm, use can be made of laser light having a long wavelength of up to 780nm.

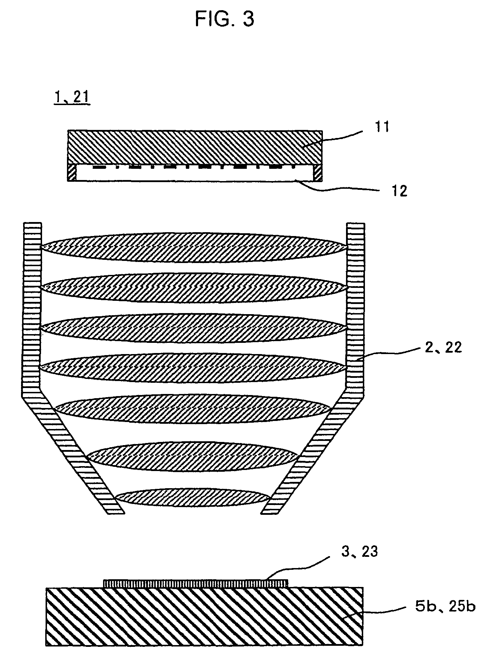

On the other hand, since the laser light irradiated onto the large-size master mask 1 has the wavelength of 193nm emitted from ArF excimer laser, a pellicle can be utilized. That is, as shown in Fig. 3, a pellicle 12 is stuck to the large-size master mask 1 at a position spaced apart from a large-size mask substrate 11 formed with the pattern. Therefore, even if particles adhere to the large-size master mask 1, no problem arises.

As described above, the mask writing system 100 according to this invention can write a mask by using only the single large-size master mask 1 that is far larger than a normal photomask. Specifically, the illustrated mask writing system 100 has the structure where the large-size master mask 1 is placed on the large-size mask stage 9 so that the large-size master mask 1 is moved on the large-size mask stage 9 in both X- and Y-directions. This structure makes it possible to write the mask by the use of the normal reduction-projection optical system 2 employed in the semiconductor device exposure system.

Further, the large-size mask stage 9 having the moving mechanism that allows the movement in two directions perpendicular to each other is a constituent component not present in the normal semiconductor device exposure system. That is, a mask stage in the normal semiconductor device exposure system is of the fixed type or the type that is reciprocatingly movable only in one direction (called a scan exposure system).

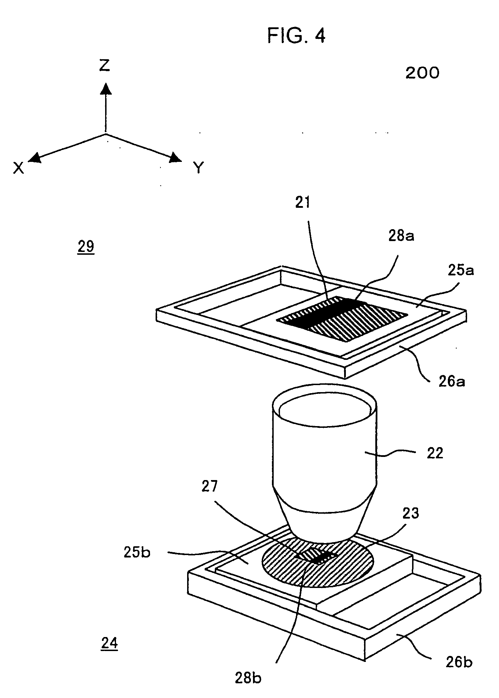

Now, referring to Fig. 4, description will be made about a mask writing system 200 according to a second embodiment of this invention. The mask writing system 200 shown in Fig. 4 comprises a large-size mask stage 29 and a mask stage 24 and is used for writing a 1:1 mask. In this connection, an intended writing pattern 27 on a mask substrate 23 has a size of 25mm in X-direction and 33mm in Y-direction, and is equal to a writing pattern size of a semiconductor device.

Since a reduction-projection optical system 22 in the illustrated mask writing system 200 is an optical system for reducing a size to 1/4, a writing area in a large-size master mask 21 is set to a size of 100mm in X-direction and 132mm in Y-direction.

The large-size master mask 21 is placed on a stage pedestal 25a constituting the large-size mask stage 29. The stage pedestal 25a is reciprocatingly movable in Y-direction within a Y-stage guide 26a.

On the other hand, the mask substrate 23 is placed on a stage pedestal 25b constituting the mask stage 24. The stage pedestal 25b is reciprocatingly movable in Y-direction within a Y-stage guide 26b.

Exposure laser light is irradiated only to a laser light irradiation area 28a in the large-size master mask 21 so that the laser light irradiation area 28a is pattern-transferred to an exposure area 28b through the reduction-projection optical system 22. However, since the large-size master mask 21 is scanned in Y-direction (i.e. one-dimensionally) and simultaneously the mask substrate 23 is scanned one-dimensionally in Y-direction opposite to the large-size master mask 21, the whole pattern of the large-size master mask 21 is formed as the writing pattern 27 in the mask substrate 23 with a size reduced to 1/4.

As a feature of the mask writing system 200 in this embodiment, since the objective mask is a 1:1 mask or a proximity mask, the size thereof is the same as the pattern size of a semiconductor device manufactured by the use of it. Therefore, not only a reduction-projection optical system of an exposure system for semiconductor device exposure can be used as the reduction-projection optical system 22, but also a mask stage of a scan exposure system for semiconductor device exposure can be used as the large-stage mask stage 29 because it requires the movement only in one direction (Y-direction).

Further, with respect to the large-size master mask 21, since a pellicle 12 is attached to a large-size mask substrate 11 like in the first embodiment as shown in Fig. 3, no problem arises even when particles adhere thereto.

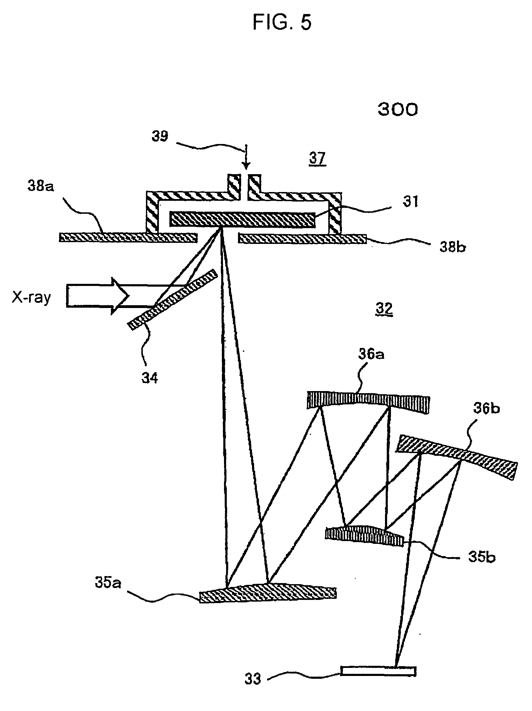

Now, referring to Fig. 5, description will be made about a mask writing system 300 according to a third embodiment of this invention. The illustrated mask writing system 300 is a system for writing a 1:1 mask for electron-beam exposure. Herein, an X-ray with a wavelength of 13.4nm is used as an exposure light source in order to cope with a particularly fine pattern. Since the resolution is proportional to a wavelength, a shorter wavelength can transfer a finer exposure pattern and therefore the use of the exposure light source with the foregoing wavelength makes it possible to transfer the fine exposure pattern.

An X-ray indicated by an arrow is reflected by a mirror 34 and irradiated onto a large-size master mask 31. The large-size master mask 31 is a reflection-type mask and the X-ray reflected thereby enters a reduction-projection optical system 32. In the reduction-projection optical system 32, the X-ray successively irradiates or hits a convex mirror 35a, a concave mirror 36a, a convex mirror 35b, and a concave mirror 36b in this order. With this structure, a pattern of the large-size master mask 31 is transferred onto a mask substrate 33 with a size reduced to 1/4.

The large-size master mask 31 and the mask substrate 33 are configured to be reciprocatingly movable leftward and rightward in the figure. With this configuration, the whole pattern of the large-size master mask 31 is transferred onto the mask substrate 33 by irradidating the X-ray over the whole pattern surface of the large-size master mask 31.

In this embodiment, since the exposure light source is the X-ray, a pellicle cannot be used for the large-size master mask 31 as different from the foregoing embodiments. However, this illustrated embodiment has a structure where the large-size master mask 31 is covered with an openable and closable cover 37. The cover 37 comprises shutters 38a and 38b and a cavity provided behind the shutters. The large-size master mask 31 is opened and closed by the use of the shutters 38a and 38b. The X-ray is incident on the large-size master mask 31 between the shutters 38a and 38b and reflected by the large-size master mask 31.

It is configured that a gas 39 can be injected from above into the illustrated cavity of the cover 37 so that particles are quite difficult to enter. Therefore, the large-size master mask 31 has a particle-free structure like an optical mask having a pellicle. The gas 39 is preferably helium having high permeability with respect to the X-ray having the wavelength of 13.4nm.

As described above, in this embodiment, with respect to the photomask and the reduction-projection optical system constituting this invention, those for the X-ray with the wavelength of 13.4nm employed in the EUVL are utilized as they are. However, using the cover 37 makes it difficult that particles are adhered to the large-size master mask 31 and, therefore, the effect similar to those in the foregoing embodiments can be obtained.

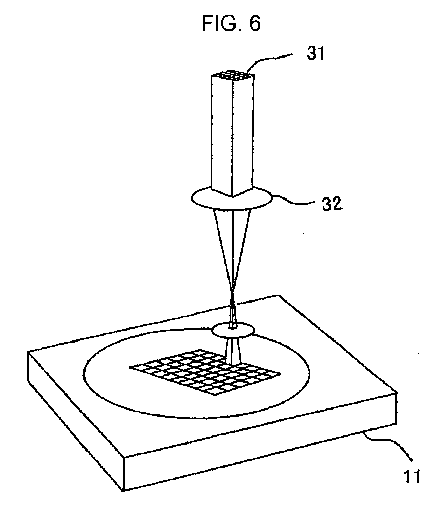

Referring to Fig. 6, description will be made about one example of a method of writing the large-size master mask 1 or 21 shown in Fig. 1 or 4. In the illustrated example, it is assumed that an objective mask to be written has a size of 100×132mm. In this case, provision is at first made about a large-size master mask substrate 11 having a size (400x528mm) equal to four times the objective mask.

Then, the large-size master mask substrate 11 is attached to an exposure system using a laser of ArF, KrF, or the like. In this example, the exposure system comprises a mirror array 31 with a plurality of micromirrors arranged two-dimensionally and the micromirrors constituting the mirror array 31 are individually controlled based on data from a mask pattern data device (not shown).

Laser light is irradiated onto the mirror array 31 from the light source of ArF laser or the like (not shown) and reflected by the respective micromirrors constituting the mirror array 31. The reflected laser light reflected by the mirror array 31 has a pattern corresponding to data given from the pattern data device and is guided to the large-size master mask substrate 11 through a lens system 32. As a result, an image of the mirror array 31 is projected onto the large-size master mask substrate 11. The pattern formed by the mirror array 31 is part of an intended writing pattern and such part of the writing pattern is projected onto the large-size master mask substrate 11 in an enlarged form.

Subsequently, by moving the large-size master mask substrate 11 in sequence, the writing pattern is written on the large-size master mask substrate 11 so that a large-size master mask is formed.

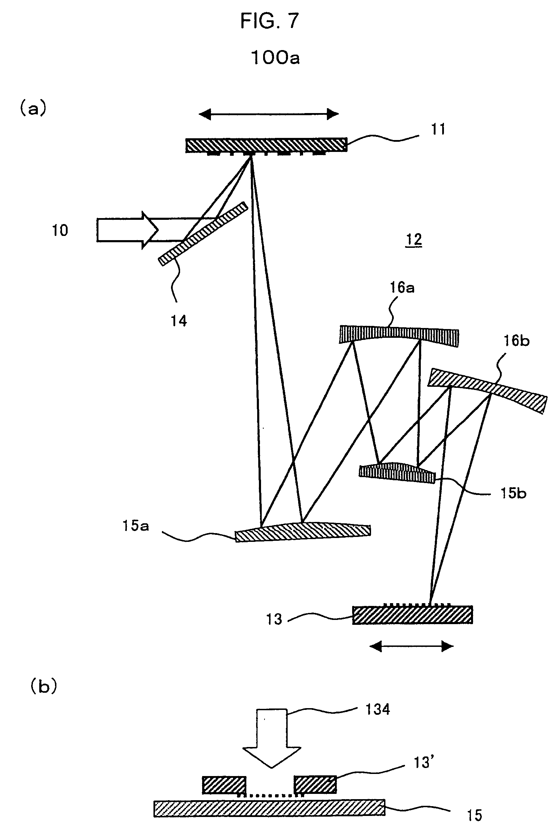

Referring to Figs. 7 (a) and (b), description will be made about a schematic structure of an exposure system 100a that realizes an exposure method according to another embodiment of this invention.

Fig. 7 (a) shows a process of writing a 1:1 mask or a proximity mask based on the exposure method of this invention, wherein the basic structure is equivalent to that of the EUVL. Fig. 7 (b) shows pattern exposure for manufacturing a semiconductor device by the use of the 1:1 mask written in Fig. 7 (a).

In Fig. 7 (a), a soft X-ray 10 having a wavelength of 13.4nm is reflected by a mirror 14 and hits a master mask 11 being a first mask constituting part of this invention. The master mask 11 is a reflection-type mask and the X-ray reflected thereby enters a reduction-projection optical system 12. The reduction-projection optical system 12 includes a convex mirror 15a, a concave mirror 16a, a convex mirror 15b, and a concave mirror 16b and the reflected X-ray successively projects or hits the convex mirror 15a, the concave mirror 16a, the convex mirror 15b, and the concave mirror 16b in the order named. By this, a pattern of the master mask 11 is transferred onto a mask substrate 13 with a size reduced to 1/4.

The master mask 11 and the mask substrate 13 are reciprocatingly movable leftward and rightward as indicated by arrows in the figure. Thus, the whole pattern of the large-size master mask 11 is transferred onto the mask substrate 13 by hitting of the soft X-ray 10 over the whole pattern surface of the master mask 11.

In this embodiment, the output of the soft X-ray 10 is only 0.1W and the reflectance of each of the mirror 14, the master mask 11, the convex mirror 15a, the concave mirror 16a, the convex mirror 15b, and the concave mirror 16b is about 70% so that the output of the soft X-ray irradiated onto the mask substrate 13 is very small like about 0.01W. As a result, in the case where the area for forming a pattern in the mask substrate 13 is about 10cm² and the sensitivity of a resist in the mask substrate 13 is 10mJ/cm², exposure of the whole pattern requires 10 seconds.

Assuming that exposure is performed for semiconductor chips by the use of the foregoing soft X-ray, since about 60 semiconductor chips are obtained per wafer, as long as about 10 minutes are required for each wafer so that the throughput is about 6/h, which is very low and is thus not practical.

On the other hand, in this invention shown in Fig. 7, since the mask is written by the use of the soft X-ray, only the single mask pattern is exposed onto the mask substrate 13 and therefore the next process can be started after 10 seconds.

The pattern-exposed mask substrate 13 is formed into a 1:1 mask or proximity mask 13' having a pattern portion in the form of a thin film as shown in Fig. 7 (b), through processes such as development, postbake, etching, and resist stripping.

In the exposure method according to this invention, the 1:1 mask 13' is placed immediately above a wafer 15 (i.e. proximity placement) and an electron beam 134 is irradiated from above the 1:1 mask 13'. By this, a pattern of the 1:1 mask 13' is exposed onto the wafer 15. This exposure is similar to semiconductor device exposure that is carried out by the use of the LEEPL technology. Since one pattern exposure can be carried out within a short time of about one second in the LEEPL, the semiconductor device exposure can be performed at a high speed like in the conventional LEEPL.

Since, as described above, the pattern is exposed onto the wafer 15 on the same scale, the line width of the exposed pattern becomes equal to that of the 1:1 mask 13'. On the other hand, as shown in Fig. 7 (a), the pattern of the master mask 11 is pattern-exposed onto the 1:1 mask 13' through the 1/4 reduction-projection optical system 12. Accordingly, the line width of the pattern of the master mask 11 is as thick as four times the line width of the 1:1 mask 13' and, therefore, even if the conventional electron-beam writing system or the like is used for writing the master mask 11, it is possible to implement pattern exposure with high accuracy. The laser-beam writing system using laser light or the like may also be used in place of the electron-beam writing system.

Further, a hard X-ray having a wavelength of about 0.1 nm may be used in place of the electron beam 134 in this embodiment. Also in this case, since exposure for each semiconductor chip can be implemented in a short time of about one second like the conventional 1:1 X-ray exposure, exposure processing with high throughput is enabled.

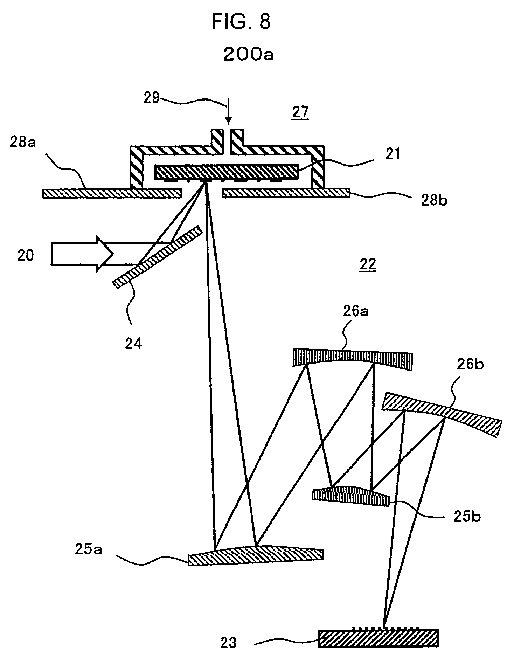

Now, description will be made about a mask writing method of this invention on the basis of an exposure method of this invention. Herein, description will be made by using a mask writing system 200a of this invention shown in Fig. 8. In the illustrated example, a soft X-ray 20 having a wavelength of 13.4nm is reflected by a mirror 24 and hits a master mask 21. The master mask is a reflection-type mask and the soft X-ray 20 reflected thereby enters a reduction-projection optical system 22. The reduction-projection optical system 22 comprises a convex mirror 25a, a concave mirror 26a, a convex mirror 25b, and a concave mirror 26b and the reflected soft X-ray hits them in the order named. By this, a pattern of the master mask 21 is transferred onto a mask substrate 23 with a size reduced to 1/4. The master mask 21 and the mask substrate 23 are reciprocatingly movable leftward and rightward as indicated by arrows in the figure. With this structure, the whole pattern of the master mask 21 is transferred onto the mask substrate 23 by hitting of the soft X-ray 20 over the whole pattern surface of the master mask 21.

In this embodiment, the master mask 21 is covered with an openable and closable cover 27. The cover 27 is provided with shutters 28a and 28b and the soft X-ray 20 can enter and reflect between them. Further, it is configured that a gas 29 can be injected from an upper portion in the cover 27 so that particles are quite difficult to enter. The gas 29 is preferably helium having high permeability with respect to the soft X-ray having the wavelength of 13.4nm.

As a feature of this embodiment, particles are difficult to adhere to the master mask 21. On the other hand, it often happens that a non-illustrated actual 1:1 mask for device exposure becomes unavailable due to adherence of particles. In this embodiment, since use is made of the master mask 21 to which particles are difficult to adhere, it is possible to remake an actual 1:1 mask for device exposure in a short time.

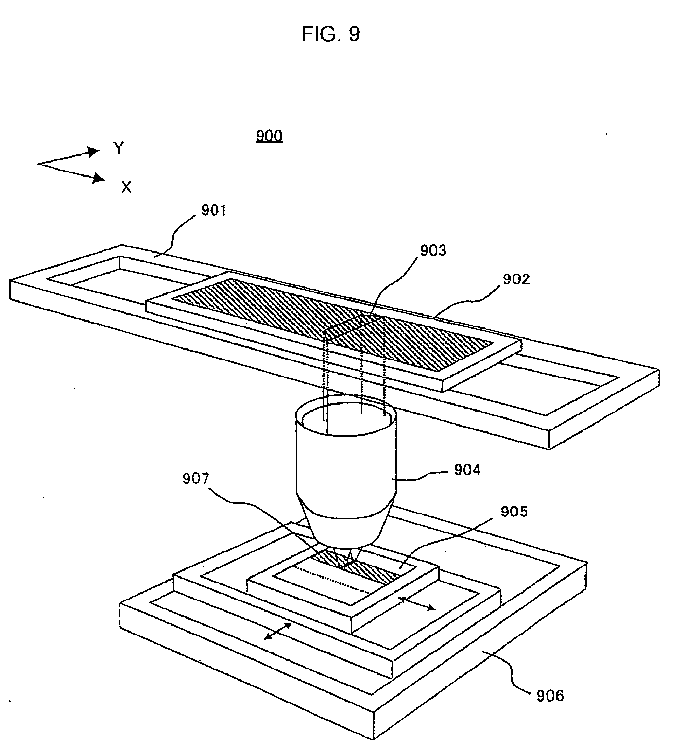

Fig. 9 is a diagram showing a structure of a mask repeater 900 according to still another embodiment of this invention. The illustrated mask repeater 900 is configured to have a scan exposure mechanism. However, a laser device as an exposure light source, a beam shaper for laser light, and so on are omitted from this figure. Laser light for exposure is shaped into a trapezoidal contour in section and then irradiated to a laser light irradiation area 903 in a writing area indicated by hatching in a master mask 902 placed on a mask stage 901. A pattern within the laser light irradiation area 903 in the master mask 902 is reduced in size to 1/4 and projected onto a mask 905 placed on an XY stage 906. The master mask 902 reciprocatingly moves in X-direction (scan direction) within the mask stage 901. On the other hand, the mask 905 reciprocatingly moves in X-direction within the XY stage 906 in a direction opposite to the master mask 902.

In this embodiment, the writing area in the master mask 902 has a size with a length (X-direction) of 528mm and a width (Y-direction) of 104mm and thus is an area elongated in X-direction. That is, this embodiment is available for that maximum of 33mm in the longitudinal direction which corresponds to a semiconductor chip size to be manufactured. Therefore, a scan stroke in the mask stage 901 is set to about 530mm in order to ensure 528mm. Accordingly, a pattern projected portion 907 in the mask 905 is formed by 1/4 reduction projection of such a writing area through a reduction-projection optical system 904. The pattern projected portion 907 has a size of 132mm in a scan direction (length) and 26mm in a step direction (width). Therefore, when the pattern projected portion 907 is stepped only four times in Y-direction, it is possible to implement pattern writing over the whole writing area of the mask 905.

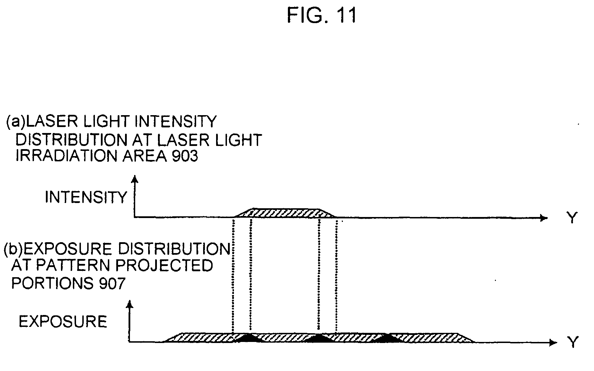

Further, since stitch exposure necessary in the mask 905 is required only at stitch portions in the step direction (Y-direction), oblique exposure can be realized by setting the laser light irradiation area 903 to a trapezoidal shape and, as shown in Fig. 11, a uniform exposure amount can be easily achieved at the pattern projected portions 907. With respect to the scan direction, since the stitch exposure becomes unnecessary, there is no occurrence of abnormal exposure.

The reason why the shape of the master mask 902 is elongated only in the scan direction in this embodiment is as follows. Specifically, if a master mask is used which has lengths equal to four times that of the mask 105 both in X- and Y-directions, i.e. a master mask area equal to 16-times the mask area, not only the reduction-projection optical system 904 should be redesigned which has lenses of four-times, but also, since the master mask has the large area, flexure due to its self-weight increases to an unignorable amount. On the other hand, in the case of the master mask 102 of this embodiment, since the width in Y-direction is 104mm and is equal to that of the normal mask (writing area), not only lenses of the normal exposure system can be used for the reduction-projection optical system 904, but also, since both ends in Y-direction of the master mask 902 are supported on the mask stage 901, any flexure does not occur in the longitudinal direction (X-direction) along which large flexure might take place. Therefore, defocusing due to flexure does not also appear at the pattern projected portion 907.

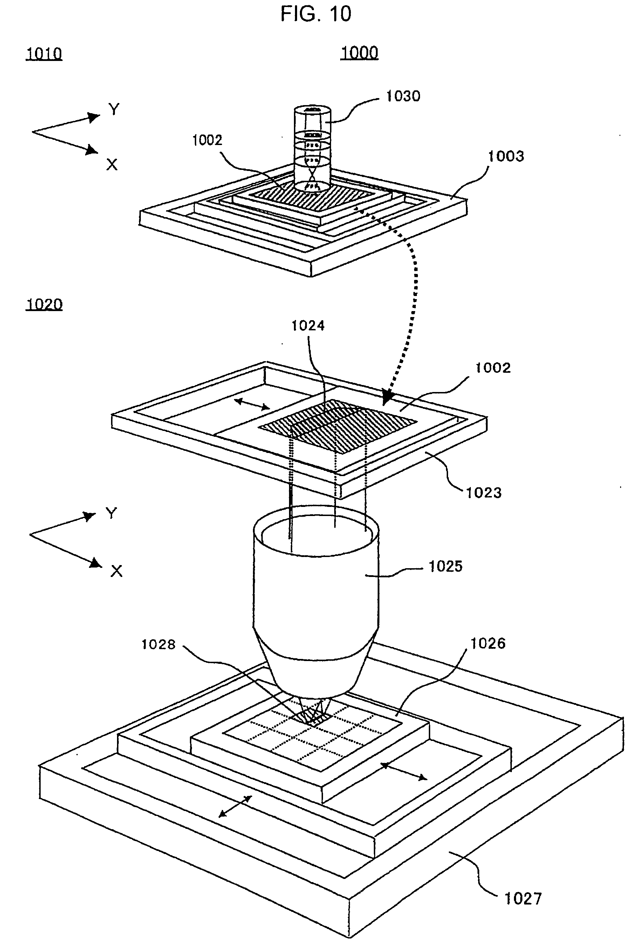

Referring now to Fig. 10, there is shown a schematic structure of a mask writing system 1000 used in this invention. The illustrated mask writing system comprises a pattern writing system 1010 and a mask repeater 1020. The illustrated pattern writing system 1010 is a system for writing a master mask 1002 and comprises an XY stage 1003 and a light pattern generating portion 1030.

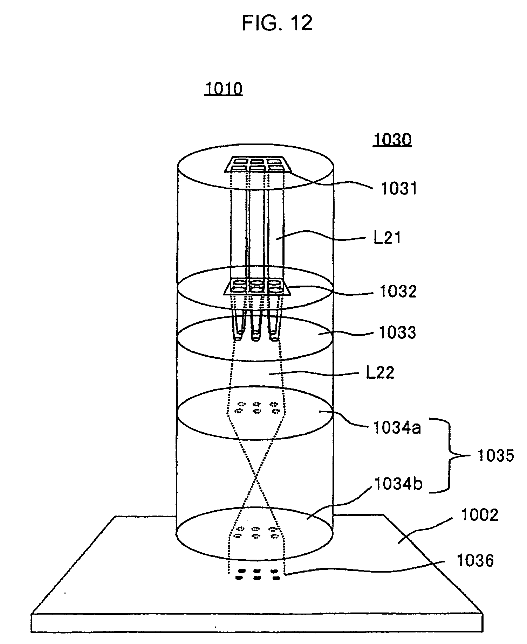

Now, this pattern writing system 1010 will be described in detail with reference to Fig. 12. In the light pattern generating portion 1030 of the pattern writing system 1010 in this invention, laser light supplied from a non-illustrated ultraviolet laser device hits a DMD 1031, then reflected laser light L21 passes through a microlens array 1032 to be narrowed and is converged on a pinhole plate 1033. The pinhole plate 1033 has a quartz glass plate with a metal film formed thereon and the metal film has a large number of fine holes each having a diameter of about one micron. These fine holes correspond to micromirrors of the DMD 1031, respectively. The size of each micromirror in the DMD 1031 is set to about 14 microns.

A light source used in the conventional pattern writing system is formed by a semiconductor laser with a wavelength of 405nm or the like. On the other hand, as the light source used in the pattern writing system 1010 of this invention, use is made of the ultraviolet laser device that continuously oscillates at the fourth harmonic wave of a YAG laser with a wavelength of 266nm. Therefore, if the light pattern generating portion 1030 employs a structure equivalent to the conventional one, a malfunction takes place in the DMD 1031 with time.

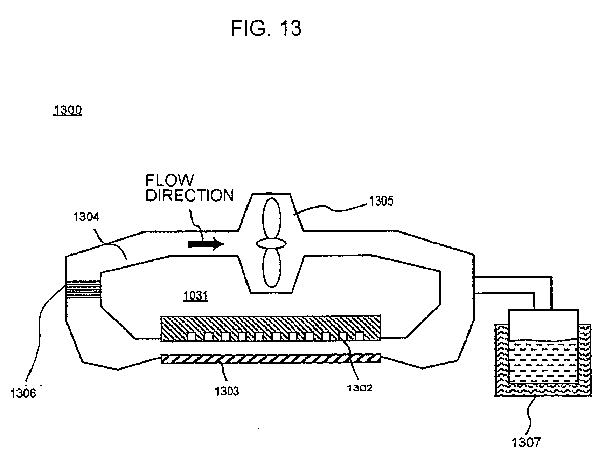

In view of this, in this invention, as shown in Fig. 13, the DMD 1031 is incorporated in an ultraviolet-adapted DMD drive mechanism 1300. In the ultraviolet-adapted DMD drive mechanism 1300, the DMD 1031 is disposed in a circulation system 1304 and a gas that contacts with micromirrors 1302 of the DMD 1031 is circulated within the circulation system 1304 by a fan 1305. The circulation system 1304 is provided therein with a cleaning filter 1306. In the DMD 1031, the micromirrors are supported by posts and a pair of landing pads are provided on both sides of each micromirror. A lubricating oil is applied to the respective landing pads. With the structure shown in Fig. 13, it is possible to capture molecules of the lubricating oil on the landing pads that were decomposed by irradiation of the ultraviolet light. The gas filled in the circulation system 1304 is preferably a noble gas such as He or Ar that is hardly decomposed even by the irradiation of the ultraviolet light.

Further, the circulation system 1304 is provided with a port leading to a lubricating oil vapor supply tank 1307 so that vapor of the lubricating oil is supplied into the circulation system 1304. A fluorine-based polymer with the same components as those of the lubricating oil on the landing pads is filled in the lubricating oil vapor supply tank 1307. The lubricating oil vapor supply tank 1307 is heated to about 50°C so that vapor of the lubricating oil is generated in an amount compensating for a decrease of the lubricating oil on the landing pads that is consumed by decomposition. The reason for filling the fluorine-based polymer in the lubricating oil vapor supply tank 1307 is that since the fluorine-based polymer has high permeability in the ultraviolet region, even if vapor thereof is filled between the micromirrors 1302 and a window 1303 in the DMD 1031, the incident ultraviolet laser light is hardly attenuated. The fluorine-based polymer is preferably, for example, a fluorine-based lubricating oil called DEMNUM manufactured by Daikin Industries, Ltd. or the like.

As shown in Fig. 13, the noble gas filled in the circulation system 1304 flows in a direction of an arrow in the figure. The reason therefor is that decomposed products of the lubricating oil generated in the DMD 1031 can be immediately removed by the cleaning filter 1306 and vapor of the lubricating oil supplied from the lubricating oil vapor supply tank 1307 can be immediately filled in the DMD 1031.

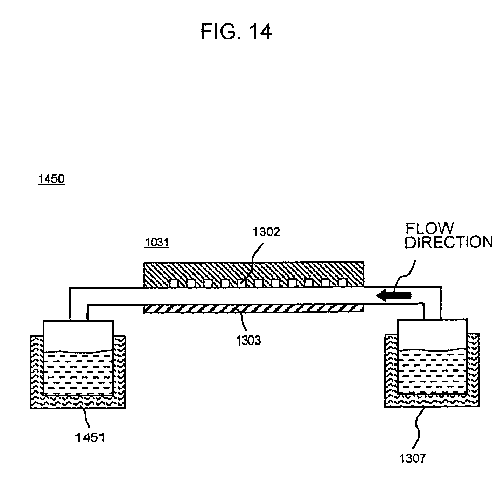

Now, an alternative for the ultraviolet-adapted DMD drive mechanism 1300 shown in Fig. 13 is shown in Fig. 14. Fig. 14 is a structural diagram of an ultraviolet-adapted DMD drive mechanism 1450. The ultraviolet-adapted DMD drive mechanism 1450 does not use the fan 1305 used in the ultraviolet-adapted DMD drive mechanism 1300 shown in Fig. 13. However, vapor of the lubricating oil moves as indicated by an arrow by connecting a lubricating oil vapor supply tank 1307 and a degraded lubricating oil recovery tank 1451 to the DMD 1031 on mutually opposite sides. The reason thereof is that the lubricating oil vapor supply tank 1307 is heated to about 50°C while the degraded lubricating oil recovery tank 1451 is cooled to about 10°C. As a result, the vapor naturally moves. As described above, the structure of the ultraviolet-adapted DMD drive mechanism 1450 is simplified as compared with the ultraviolet-adapted DMD drive mechanism 1300 shown in Fig. 13.

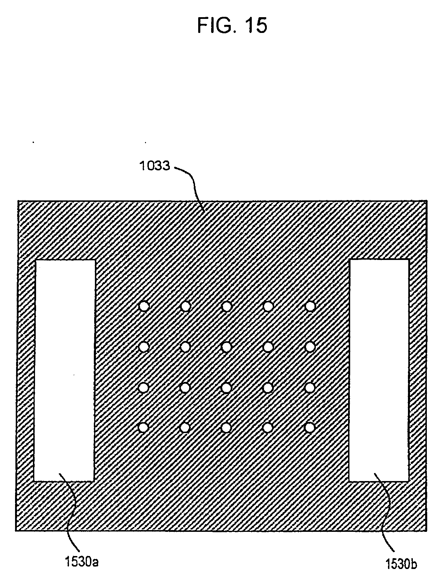

Now, referring to Fig. 15, description will be made about a structure of this invention and will be directed to improvement of the writing performance of the pattern writing system 1010 of this invention shown in Fig. 12. In the pinhole plate 1033 used in the light pattern generating portion 1030 of the pattern writing system 1010, the metal film is provided with the holes each of which has the diameter of about one micron and is formed on the quartz glass plate.

On the other hand, since the reduction magnification of the microlens array 1032 is about 1/4, spots on the pinhole plate 1033 each have a diameter of about 3.5 microns. In the conventional system, the hole diameter of the pinhole plate 1033 was set to 3.5 microns to thereby take out the laser light without waste. However, since the reduction magnification of a reduction-projection optical system 1035 was about 1/5, the diameter of each of spots forming a DMD projection pattern 1036 was about 0.7 microns. If the reduction magnification of the reduction-projection optical system is increased, the spot diameter on the master mask 1002 can be reduced, but there has also been a problem that since the DMD projection pattern 1036 itself is diminished in size, a writing time is resultantly prolonged.

On the other hand, in this invention, since the hole diameter in the pinhole plate 233 is about one micron, the diameter of each spot forming the DMD projection pattern 1036 is as small as about 0.2 micron so that a pattern finer than a conventional technique can be formed without reduction in size of the DMD projection pattern 1036 itself. However, since the diameter of each spot converged by the microlens array 1032 is about 3.5 microns, the rate of the quantity of laser light that can pass through the hole of about one micron in the pinhole plate 1033 is about 8% and, therefore, about 92% of the laser light is wasted to heat the pinhole plate 1033. In view of this, in this embodiment, Peltier elements 1530a and 1530b are formed on both sides of an array of the pinholes in the pinhole plate 1033 to thereby forcibly cool the pinhole plate 1033 during exposure. It is noted here that the surface where the Peltier elements 1530a and 1530b are formed is the surface where the foregoing metal film is formed in the pinhole plate 1033. This is because the thermal conductivity of the metal film is large and therefore, the effect of cooling the whole pinhole plate 1033 is enhanced.

As described above, in the pattern writing system 1010 of this invention, since the pinhole plate 1033 can be cooled during exposure, the pinhole plate 1033 is not undesirably increased in temperature and is thus not largely increased in thermal expansion. Therefore, the relative positions of the respective pinholes are not largely shifted during exposure so that the DMD projection pattern 1036 is precisely projected at a position pursuant to a design in the master mask 1002.

As described above, in the pattern writing system 1010 according to this invention, since, particularly, the pinhole plate 1033 having the sufficiently fine holes of about one micron can be used without increasing the reduction magnification of the microlens array 1032, even when the spot diameter in the pattern of the DMD 1031 can be reduced to about 0.2 microns, it is possible to use the low magnification like the reduction magnification of about 1/4 to 1/5 for the reduction-projection optical system 1035.

This structure makes it possible to use a reduction-projection optical system in a normal i-line exposure system or a reduction-projection optical system in a KrF exposure system, as the reduction-projection optical system 1035. Since these exposure systems are mass-produced by exposure system makers, the reduction-projection optical system can be obtained at a low price so that the pattern writing system 1010 can be manufactured at a low cost. It is well known that the reduction magnification of the reduction-projection optical system in the i-line exposure system is 1/5 and the reduction magnification of the reduction-projection optical system in the KrF exposure system is 1/4. However, the reduction magnification of each of these reduction-projection optical systems is not precisely 1/4 or 1/5, but is generally adjustable between 1/3.5 and 1/4.5 or between 1/4.5 and 1/5.5. Therefore, in this invention, it is possible to achieve a reduction in cost of the system particularly by the use of the reduction-projection optical system for the exposure system.

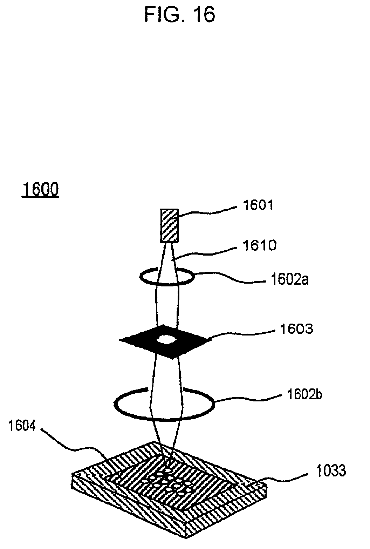

Now, referring to Fig. 16, description will be made about a technique of manufacturing the pinhole plate 1033 used in this embodiment. The pinhole plate 1033 of this embodiment is formed by a quartz glass serving as a substrate and a metal film formed thereon. Preferably, the metal film is of copper, aluminum, gold, or the like having a high thermal conductivity. Particularly, copper is most preferable because it can also be attached by plating and can be manufactured at a low cost.

It is preferable to use an electron-beam exposure system 1600 in order to form a hole in the metal film. In the electron-beam exposure system 1600, accelerated electrons 1610 emitted from an electron gun 1601 are progressive and slightly narrowed by an electron lens 1602a and hit an aperture 1603 formed with a round hole. The electrons passing through the hole of the aperture 1603 are reduction-projected through an electron lens 1602b onto the pinhole plate 1033 (namely, the quartz glass plate with the metal film having no pinhole at this time instant) and are projected onto a resist 1604 to expose the resist 1604 in a hole shape. After completion of the exposure with respect to all holes, the pinhole plate 1033 applied with the resist 1604 is developed and further wet-etched so that a large number of fine holes are formed in the metal film.

The reason for using the electron-beam exposure system 1600 in order to form the holes in the metal film as described above is because a slight distance of the electron beam can be corrected instantaneously at every one of several nanometers by the use of the electron lens 1602b. This makes it possible to implement spot exposure on the substrate with a high position accuracy of several nanometers or less.

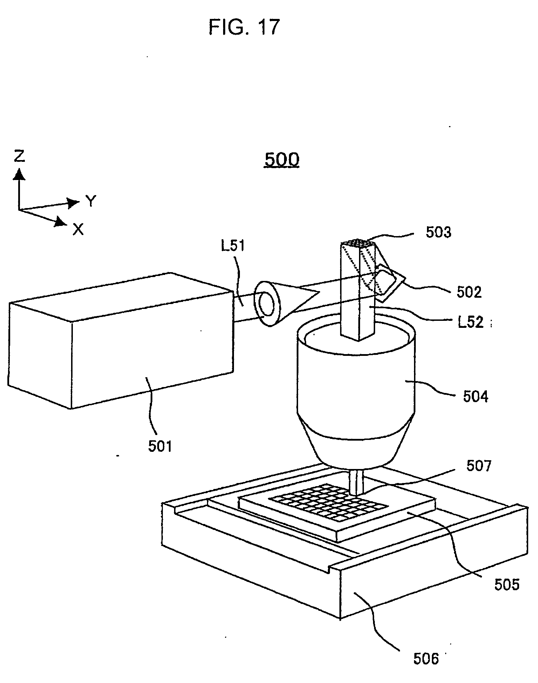

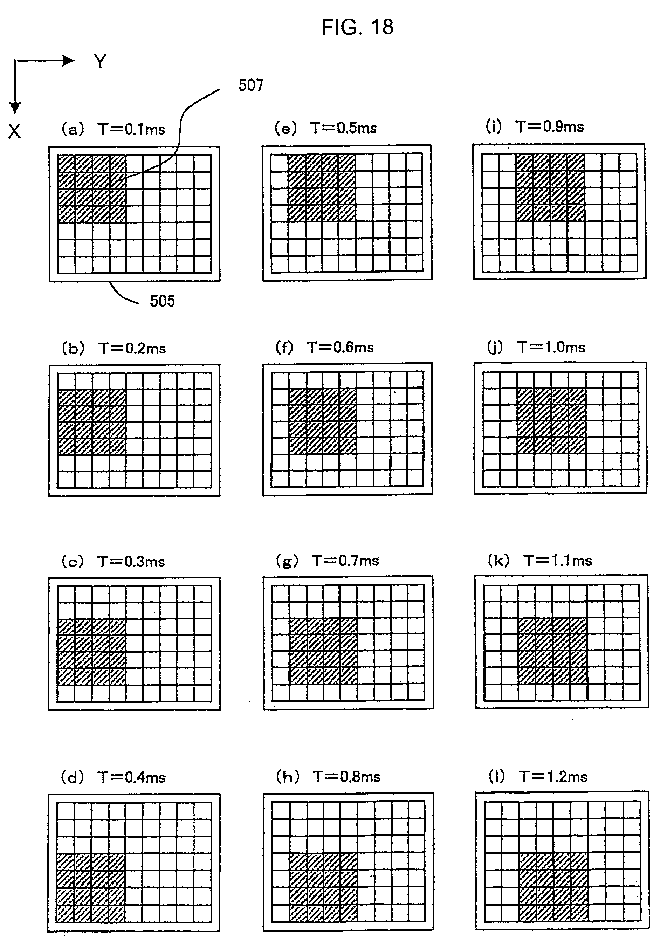

Now, referring to Figs. 17 and 18, description will be made about a writing technique of this invention in a pattern writing system in which a pattern of a DMD is directly reduction-projected. Fig. 18 is an explanatory diagram showing, in time sequence from (a) to (I), projecting positions of a DMD projection pattern 507 on a substrate 505 when a pulse laser device 501 and a DMD 503 are operated at 10,00OHz. In Figs. 17 and 18, the number of projected micromirrors shown are reduced in number in order to facilitate understanding. The DMD projection pattern 507 projected onto the substrate 505 is indicated by hatching. As seen from these figures, the DMD projection pattern 507 projected in X-direction per 0.1 ms is projected with a part overlapped in X-direction by scanning of the substrate 505. On the other hand, by stepping in Y-direction in an XY stage 506, projection is implemented with a partial overlap in transfer caused to occur also in Y-direction. For example, (a), (e), and (i) are overlapped in transfer in Y-direction. In this invention, the transfer of the DMD projection pattern 507 is overlapped in both X and Y of two directions as described above, thereby realizing a gray scale. As a result, errors in both scan and step positions are averaged to make unnecessary the stitch exposure in the step direction so that no abnormal exposure occurs.

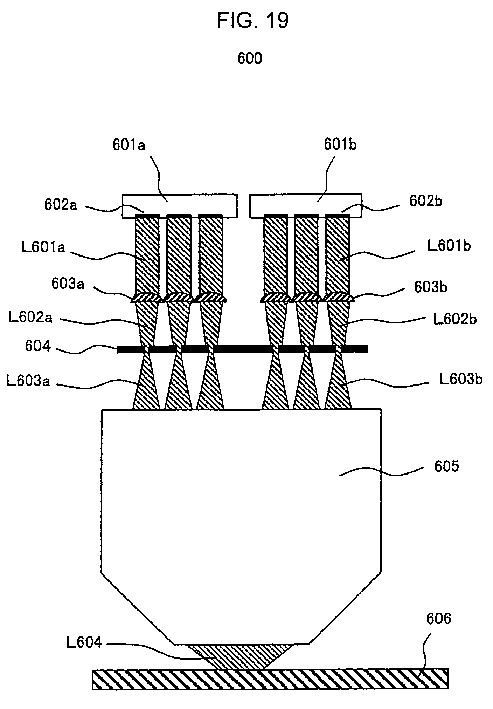

Referring now to Fig. 19, there is shown a structural diagram of a pattern writing system 600 according to another embodiment of this invention. The pattern writing system 600 is the same as the pattern writing system 1010 shown in Fig. 12 in that it has a structure where laser light from respective micromirrors of a DMD is converged on a pinhole plate through a microlens array and a large number of light beams passing through holes of the pinhole plate are pattern-transferred onto a substrate through a reduction-projection optical system. However, this embodiment differs from the pattern writing system of Fig. 12 in that two DMDs are used for improving the writing speed.

Specifically, when laser light from a non-illustrated ultraviolet laser device is incident on DMDs 601 a and 601 b, the laser light for use in writing is progressive from micromirrors 602a and 602b like laser lights L601 a and L601 b, respectively. Then, the laser lights L601a and L601b are incident on microlens arrays 603a and 603b and progressive and narrowed like laser lights L602a and L602b. The laser lights L602a and L602b are irradiated onto a single pinhole plate 604, then laser lights L603a and L603b that pass through holes enter a single large-diameter reduction-projection optical system 605 to be thereby irradiated onto a substrate 606 like laser light L604. Thus, a pattern at the position of the pinhole plate 604 is projected onto the substrate 606.

A feature of this embodiment resides in that although the two DMDs 601a and 601b are used, the single pinhole plate 604 is used. With this structure, even if the relative distance between the two DMDs 601a and 601 b or the relative distance between the two microlens arrays 603a and 603b deviates by about several microns due to thermal expansion or the like, there is no change in positions of a large number of spots being a pattern projected onto the substrate 606. Although using the two DMDs is explained in this embodiment, even if a larger number of DMDs are used, it is desirable to configure the system with the single pinhole plate.

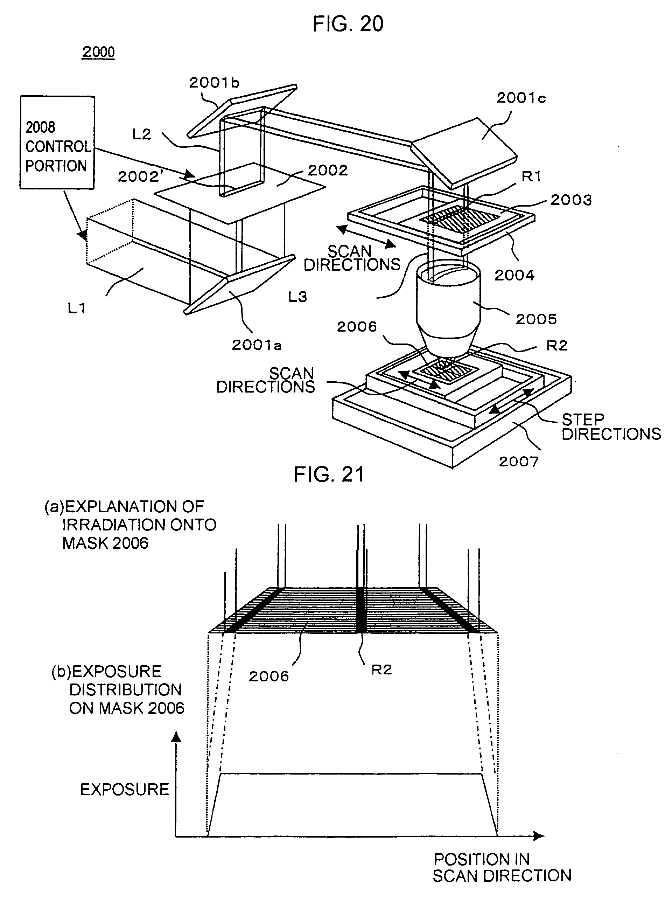

Fig. 20 is a structural diagram of a mask writing system 2000 of this invention. In the mask writing system 2000, laser light L1 serving as exposure light is reflected by a mirror 2001 a and then irradiated onto a slit plate 2002. The slit plate 2002 is provided with an elongated opening 2002' having a width of 4mm and a length of 104mm. Laser light L2 passing through the opening 2002' is reflected by mirrors 2001 b and 2001c and irradiated to an irradiation area R1 in a master mask 2003. The master mask 2003 is movable for scanning leftward and rightward in the figure as indicated by arrows within a master mask stage 2004. Laser light L3 emitted from the irradiation area R1 of the master mask 2003 enters a reduction-projection optical system 2005 and illuminates an irradiation area R2 of a mask 2006. That is, an image of the irradiation area R1 in the master mask 2003 is reduced to a size of 1/4 and projected onto the irradiation area R2 of the mask 2006 through the reduction-projection optical system 2005. Accordingly, in this embodiment, the irradiation area R2 has a width of 1 mm and a length of 26mm. The mask 2006 is placed on a mask stage 2007 and the mask stage 2007 is driven by a driving apparatus (not shown) so as to be moved for scanning leftward and rightward as indicated by arrows in the figure. In the illustrated example, the master mask 2003 and the mask 2006 are driven by the driving apparatuses so as to be reciprocatingly movable in the opposite directions from each other. Further, the illustrated mask stage 2007 is configured so as to be movable also forward and backward in the figure, i.e. in the step directions. In this structure, a pattern on the whole surface of the master mask 2003 is transferred onto the mask 2006, then the master mask 2003 is replaced in turn and, by moving the mask 2006 not only in the scan direction but also in the step direction, patterns of the respective master masks 2003 are transferred onto the whole surface of the mask 2006.

In the mask writing system 2000, as shown in Fig. 21, (a), a control is executed by a controller 2008 such that at the moment when the irradiation area R2 is located at an end of the mask 2006 in the scan direction, laser light L1 is supplied and irradiated and, at the moment when scanning is finished once and the irradiation area R2 has reached the other end of the mask 2006, the laser light L1 is stopped. For stopping the laser light L1, laser oscillation may be stopped by a non-illustrated laser oscillator or the laser light L1 is shielded by the use of a non-illustrated shutter or the like.

According to this structure, while the exposure light is irradiated to the irradiation area R2, the mask 2006 is constantly moved (scanned) with respect to the irradiation area R2, i.e. continuously moved at a fixed scan speed. Therefore, as shown in Fig. 21, (b), the exposure amount does not become constant in a range equal to a width of the irradiation area R2 from each of both ends in the mask 2006 so that oblique exposure is realized. That is, in the ranges equal to the width of the irradiation area R2 from both ends of the mask 2006, a time of irradiation by the exposure light is shortened as approaching both ends and, as a result, the exposure amount decreases as approaching both ends so that the oblique exposure as shown in Fig. 21, (b) can be realized.

The width of the irradiation area R2 herein is 1 mm as described before and, therefore, the width of each oblique portion of the oblique exposure also becomes 1mm. Consequently, in this embodiment, stitch exposure having the width of 1 mm can be realized. In other words, in this embodiment, the width of the irradiation area R2 is set substantially equal to the width of the stitch exposure.

As described above, this embodiment in accordance with this invention makes it possible to realize the oblique exposure at both ends in the scan directions by the use of the slit plate 2002 having the prescribed opening 2002' (i.e. the opening having the width corresponding to the stitch exposure width) and, therefore, the stitch exposure can be implemented without largely modifying the conventional scan exposure system.

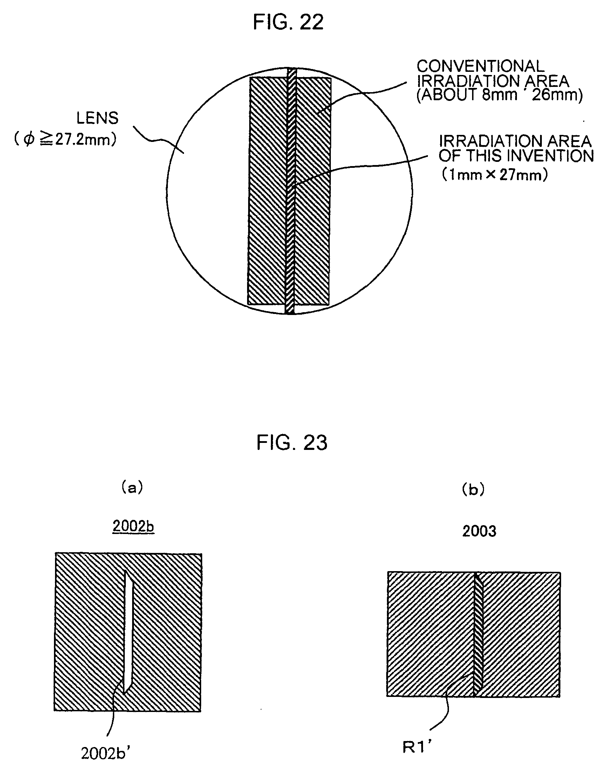

Now, referring to Fig. 22, description will be made about a new effect achieved by the mask writing method of this invention. Fig. 22 is an explanatory diagram that compares the size of the irradiation area (R2 in Fig. 20) projected onto a mask substrate for pattern exposure and the size of a lens used in the reduction-projection optical system (2005 in Fig. 20). In the conventional scan exposure system, an irradiation area is about 8mm × 26mm and, as a result, a lens having an effective diameter of 27.2mm or more is required as indicated by a circle in Fig. 22.

On the other hand, in this invention, it is necessary to form an irradiation area having a width equal to an oblique portion of oblique exposure. For example, if the width is 1 mm, when use is made of a lens having an effective diameter of 27.2mm, the length of the irradiation area can be increased to about 27mm. Accordingly, pattern exposure can be implemented onto an area having a length of 27mm in a direction perpendicular to the scan direction and, therefore, even if an area of 1 mm from the end is used for stitch exposure, a mask of the standard size can be written by 16-times the stitch connection as shown below.

Specifically, the size of a pattern area in a mask used in the normal scan exposure system for use in exposure for a semiconductor device is 132mm × 104mm. When such a pattern area is exposed by the use of a 1/4 reduction-projection optical system, a pattern of 33mm × 26mm at maximum can be transferred onto a wafer. This size is called a maximum exposure field and 26mm represents a length in a direction (step direction) perpendicular to a scan direction. However, there is a case of 25mm depending on exposure system makers.

Therefore, in the case of writing the mask having the pattern area with the size of 132mm × 104mm by the use of the conventional scan exposure system having the irradiation area of 26mm in the step direction, if the maximum exposure field is 33mm 26mm, it is necessary to repeat exposure four times in the scan direction and four times in the step direction and thus 16 times in total. In this case, when the width of 1mm is used for stitch exposure, although stitch connection is performed four times both in the lateral direction (scan direction) and the longitudinal direction (step direction), three overlapping portions are produced with respect to the direction perpendicular to the scan direction (i.e. the step direction), thereby resulting in a length of 26×4-3=101 mm. Therefore, it becomes slightly shorter than the pattern area of the normal mask.

On the other hand, as described before, in this invention, the pattern transfer can be implemented with the length of 27mm in the direction perpendicular to the scan direction and, therefore, when stitch connection is carried out four times, a length of 27×4-3=105mm is achieved so that the pattern area of the normal mask can be sufficiently covered.

As described above, in this invention, the length of the irradiation area on the mask can be set to 27mm longer than normal 26mm and, therefore, if the length in the scan direction (scan stroke) is made longer by about 3mm from normal 32mm, the maximum exposure field can be easily increased to 34.7mm × 26.4mm.

According to this, for writing a quadruple photomask having a pattern area of 132mm × 104mm, (132/26.4)×(104/34.7)=5×3=15 and, therefore, pattern writing can be implemented over the whole pattern area of a mask substrate by the use of 15 master masks. Accordingly, as compared with 16 master masks required in the foregoing normal method, one master mask can be saved.

In the foregoing example, the description has been made about the oblique exposure in the scan direction in the mask writing system 2000 shown in Fig. 20. In the mask writing system 2000 according to the embodiment of this invention, it is also possible to realize oblique exposure in the direction perpendicular to the scan direction (i.e. the step direction). In this case, a density filter may be used like conventional but, in this invention, a proposal is made of exposure using a blind 2002b having a trapezoidal opening 2002b' (i.e. a slit plate) as shown in Fig. 23, (a). That is, the slit plate 2002b is formed with the opening 2002b' having an oblique angle at both upper and lower ends thereof in the direction (step direction) perpendicular to the scan direction. In this case, the oblique angle is directed toward a center line of the slit plate 2002b.

When use is made of the slit plate 2002b having such an opening 2002b', a trapezoidal irradiation area R1' is formed as shown in Fig. 23, (b) and, therefore, when a master mask 2003 is scanned laterally, the oblique light quantity can be realized at upper and lower ends in Fig. 23, (b). That is, in each of oblique portions of the irradiation area R1' of the master mask 2003, the exposure time becomes longer as approaching the center while the exposure time becomes shorter as approaching the end. As a result, the density filter becomes unnecessary.

When irradiating the laser light L1 onto the slit plate 2002 in the mask writing system 2000 shown in Fig. 20, the sectional shape of the laser light L1 may be formed into an elongated shape by the use of a pair of cylindrical lenses. According to this, it is possible to reduce the rate of the laser light L1 to be cut by the slit plate 2 so that the laser light can be efficiently used for exposure. In Fig. 23, (a), the description has been made only about the slit plate 2002b formed with the trapezoidal opening 2002b'. However, the shape of the opening 2002b' may be rhombic.

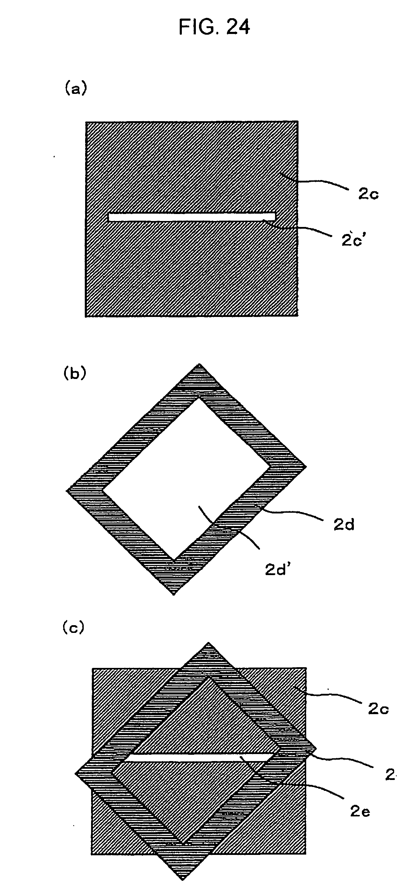

Now, referring to Fig. 24, (a), (b), and (c), another embodiment of this invention will be described. Fig. 24 shows a slit unit that is used in place of the slit plate 2002 in the mask writing system 2000 shown in Fig. 20. The illustrated slit unit comprises a slit plate 2002c shown in Fig. 24, (a) and a slit plate 2002d shown in Fig. 24, (b), which are used in combination with each other as shown in Fig. 24, (c). By combining the two slit plates 2002c and 2002d as shown in Fig. 24, (c), it is possible to constitute a slit unit having a function similar to the slit-shaped opening 2b' having both end portions formed obliquely at about 45 degrees like the slit plate 2002b shown in Fig. 23.

Specifically, the slit plate 2002c shown in Fig. 24, (a) has a rectangular elongated slit-shaped opening 2002c' extending in the direction perpendicular to the scan direction (i.e. step direction), while, the slit plate 2002d shown in Fig. 24, (b) has a large rectangular opening 2002d' so as to partly overlap the slit opening 2002c' of the slit plate 2002c. By superimposing both slit plates 2002c and 2002d so as to be mutually inclined at an angle of 45° (herein, the slit plate 2002d is inclined at an angle of 45°), the slit unit is constituted.

By superimposing the slit plates 2002c and 2002d as shown in Fig. 24, (c), there is formed an opening 2002e having both end portions formed obliquely at about 45 degrees as shown in Fig. 24, (c). By this, oblique exposure is realized at portions of both ends (two sides parallel to the scan direction) of the master mask 2003 and the mask 2006 shown in Fig. 20.

A feature of the slit plates according to this embodiment resides in that the sectional shape of laser light (laser light L2 in Fig. 20) particularly passing through the oblique end portions becomes clear and sharp. As a result, since the shape of end portions of the irradiation area R1 in the master mask 2003 becomes clear and sharp, when overlapping exposure is implemented on the mask 2006, a uniform exposure amount can be obtained over to ends of overlapping portions.

On the other hand, it is practically difficult to process a single slit plate to form a sharp slit having an oblique end portion and a roundness of about 0.1 mm is unavoidable. Specifically, as a material of the slit plate, it is necessary to use a metal having light resistance against laser light but, it is difficult to apply a processing of 0.1 mm or less to an acute angle portion of a metal plate to thereby form a sharp slit. As a result, when portions exposed by laser light passing through rounded corners of an opening are superimposed with each other, a uniform exposure amount cannot be obtained at portions on a mask corresponding to those corners.

However, as shown in Fig. 24, (c), by superimposing the two slit plates 2002c and 2002d to thereby use the two slit plates each having the rectangular opening in the superimposed manner, a practical effect has been obtained that the sectional shape of laser light emitting those openings has very sharp corners so that exposure at overlapping potions can be carried out quite uniformly.

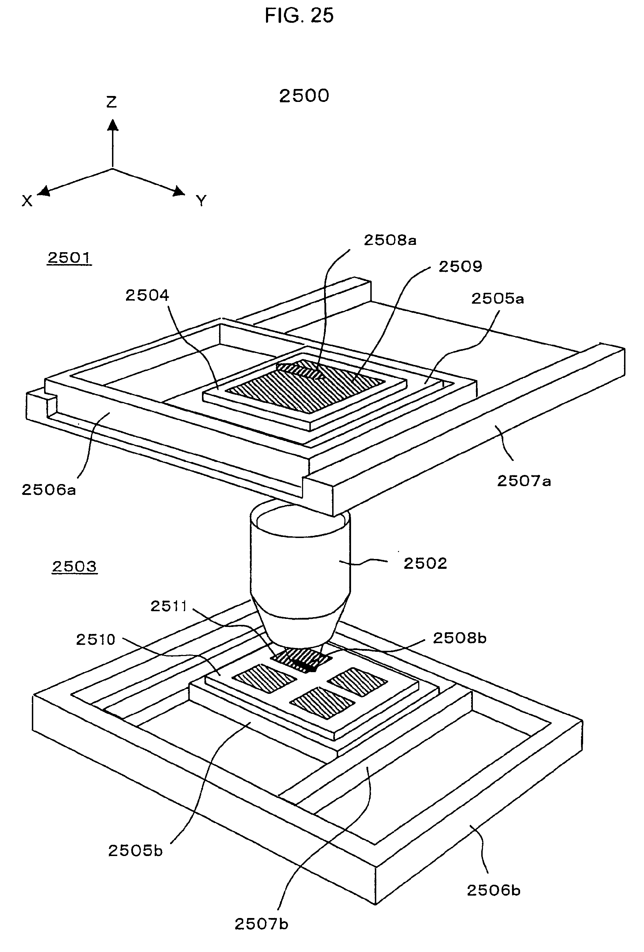

Fig. 25 is a structural diagram of a mask repeater 2500 according to still another embodiment of this invention. The mask repeater 2500 roughly comprises a master mask stage 2501, a reduction-projection optical system 2502, and a mask stage 2503. In the master mask stage 2501, a master mask 2504 of this invention is of a normal size and has each side of 152mm (generally called a 6-inch reticle). The master mask 2504 is placed on a stage pedestal 2005a. The stage pedestal 2005a is mounted on a step stage guide 2006a so as to be reciprocally movable in Y-direction. The step stage guide 2006a is mounted on a scan stage guide 2007a so that the step stage guide 2006a itself is movable for scanning in X-direction.

On the other hand, a mask substrate 2510 is placed on a stage pedestal 2005b in the mask stage 2003. The stage pedestal 2505b is mounted on a scan stage guide 2507b and, during exposure, moves for scanning, simultaneously with the scan stage guide 2507a, in an opposite direction along X-direction. Further, the scan stage guide 2507b is mounted on a step stage guide 2506b and is movable for stepping in Y-direction.

In order to perform pattern exposure onto the mask substrate 2510, exposure light is irradiated to a laser light irradiation area 2508a defined by an area elongated in Y-direction in a pattern area 2509 of the master mask 2504. With this structure, a pattern in the laser light irradiation area 2508a is projected onto a laser light irradiation area 2508b in the mask substrate 2510. Accordingly, the master mask 2504 is moved by scanning in X-direction and stepping in Y-direction so that the laser light irradiation area 2508a transfers the whole pattern area 2509 of the master mask 2504. By this, a pattern of the pattern area 2509 of the master mask 2504 can be transferred onto the whole exposure area 2511 in the mask substrate 2510.

Specifically, in Fig. 25, the laser light irradiation area 2508a, the reduction-projection optical system 2502, and the laser light irradiation area 2508b are relatively fixed. In order to allow the laser light irradiation area 2508a and the laser light irradiation area 2508b to move over the whole pattern area 2509 in the master mask 2504 and the whole exposure area 2511 in the mask substrate 2510, respectively, the master mask 2504 itself and the mask substrate 2510 itself are moved (scanned and stepped) simultaneously with each other. In this event, the exposure light is irradiated to the laser light irradiation area 2508a only at the time of scanning, i.e. moving in X-direction, to thereby pattern-expose the laser light irradiation area 2508b of the mask substrate 2510.

When the mask repeater 2500 of this embodiment is manufactured by reconstructing the normal scan exposure system as a basis, a scan stage guide 2507a of the normal scan exposure system may be utilized and a step stage guide 2506a which is compact in size and which is received in the scan stage guide 2507a may be newly manufactured. The scan exposure system serving as the basis may be KrF or ArF, while, it is preferable to use an ArF exposure system particularly of the type called an immersion optical system because high resolution can be obtained. When the immersion optical system is used, the stage pedestal 2505b may be provided with a pan for storing pure water to thereby allow the whole mask substrate 2510 to be immersed in the pure water. Differing from the normal exposure system that performs exposure for semiconductor chips, the mask repeater is not required to have so high exposure speed. That is, this is because it is necessary to finish exposure in about one second per chip in the case of the semiconductor chip exposure, while, in the case of the mask exposure, it is possible to spend an exposure time of about several minutes per mask. Therefore, since the scan speed can be set to an extremely low speed, it is possible to apply the structure of immersing the whole mask in the pure water. On the other hand, with respect to the immersion optical system used in the normal exposure system, a complicated mechanism for discharging pure water only to an exposure portion has been required for increasing the scan speed.

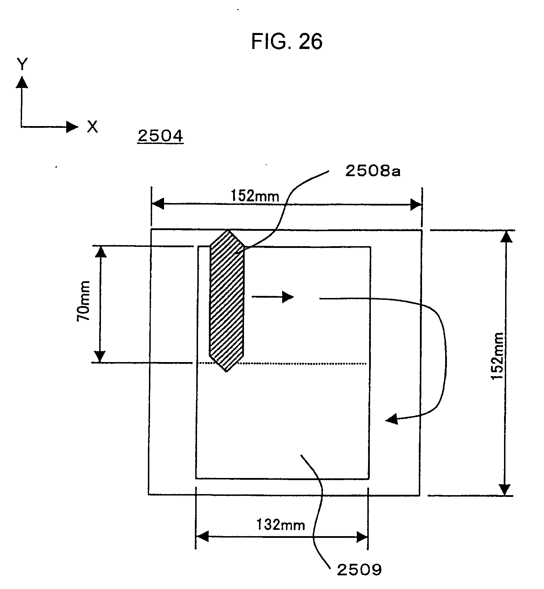

Now, referring to Fig. 26, description will be made about the sequence in which the laser light irradiation area 2508a in the master mask 2504 moves over the whole surface within the pattern area 2509. The laser light irradiation area 2508a scans the pattern area 2509 in X-direction from its left end (actually, the master mask 4 scans in -X-direction) and, after passing through its right end, the master mask 2504 is stepped in -Y-direction. Then, the laser light irradiation area 2508a is scanned in -X-direction (actually, the master mask 4 scans in X-direction) so that the laser light irradiation area 2508a passes through the whole surface within the pattern area 2509 and, as a result, the whole exposure area 2511 of the mask substrate 2510 shown in Fig. 25 is pattern-exposed. In Fig. 26, alignment marks are omitted. However, actually, the alignment marks are provided on the left and right sides of the pattern area 2509. It is preferable to provide the alignment marks at two positions on each of the left and right sides so that the four alignment marks in total are located apart from each other to form the vertices of a rectangle.

The reason that the illustrated laser light irradiation area 2508a has a hexagonal shape with both ends angled in X-direction, is because there are two areas which the laser light irradiation area 2508a passes through and these two areas are adjacent to each other and, therefore, such a shape is adopted to obtain a uniform exposure amount when exposing a stitch portion therebetween twice.

As shown in Fig. 26, the laser light irradiation area 2508a transfers a width of 70mm by scanning in one direction and, by reversing, transfers 140mm in total in Y-direction. According to this, the width (Y-direction) of the exposure area 2511 becomes 35mm through the reduction-projection optical system 2502 having a 1/4 reduction magnification. On the other hand, since the length of the pattern area 2509 in X-direction is 132mm equal to that of the normal mask, the width (X-direction) of the exposure area 2511 becomes 33mm. Therefore, in order to pattern-expose the pattern area of 104 × 132mm of the normal mask, it is only necessary to stitch patterns three times in Y-direction and four times in X-direction, i.e. twelve (12) times in total (i.e. patterns composed of 12-different master masks). This method can be reduced in the number of the master masks by four master masks, as compared with the conventional method that needs to stitch patterns 16 times (16 master masks).

On the other hand, as shown in Fig. 25, in this embodiment, four identical patterns each identical to that of the exposure area 2511 are juxtaposed on the mask substrate 2510 and it is not a case where a single large pattern is formed from four different master masks. That is, the whole pattern of one semiconductor chip can be obtained by the pattern area 2509 of the master mask 2504. According to this, four identical patterns of the pattern area 2509 of the master mask 2504 are projected onto the mask substrate 2510. According to this, in the exposure system using the mask substrate 2510, exposure for four semiconductor chips can be achieved at a time by one-time exposure on a wafer.

The feature that facilitates writing of the mask capable of exposure for a plurality of the same semiconductor chips at a time as described above is obtained when the mask repeater is used and, as compared with the case where a plurality of the same patterns on a mask are written one by one by the use of the electron-beam writing system or the like, a required time is largely shortened.

In this embodiment, as shown in Fig. 26, the reticle called the 6-inch reticle with each side being 152mm is used as the master mask. However, a reticle called a 9-inch reticle with each side being about 229mm may be used as the master mask 2504. In this case, the width of the pattern area 2509 in Y-direction can be increased to 208mm which is twice the width of 104mm of the normal mask.

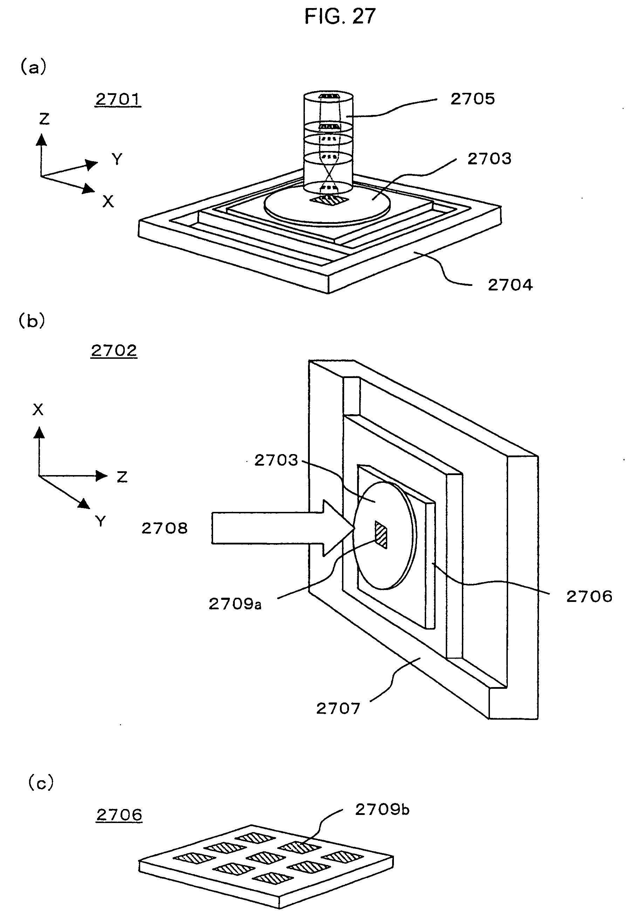

Fig. 27, (a), (b), and (c) are diagrams for explaining a mask writing method according to another embodiment of this invention. In the mask writing method of this embodiment, use is made of a master mask writing system 2701 shown in Fig. 27, (a) and a mask repeater 2702 of this invention shown at (b).

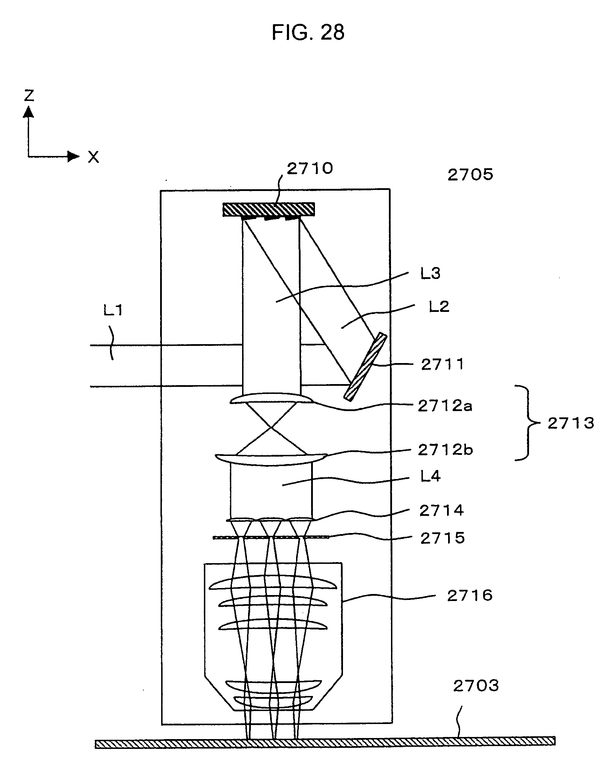

At first, in the master mask writing system 2701 shown in Fig. 27, (a), a master mask 2703 set on an XY stage 2704 is pattern-exposed by a pattern writing system 2705. Details of the pattern writing system 2705 will be described later with reference to Fig. 28. The master mask 2703 thus written comprises a silicon substrate and a SiC membrane formed thereon. An X-ray absorber in the form of a heavy metal layer is formed on the SiC membrane and then pattern-exposed, thereby writing the master mask 2703.

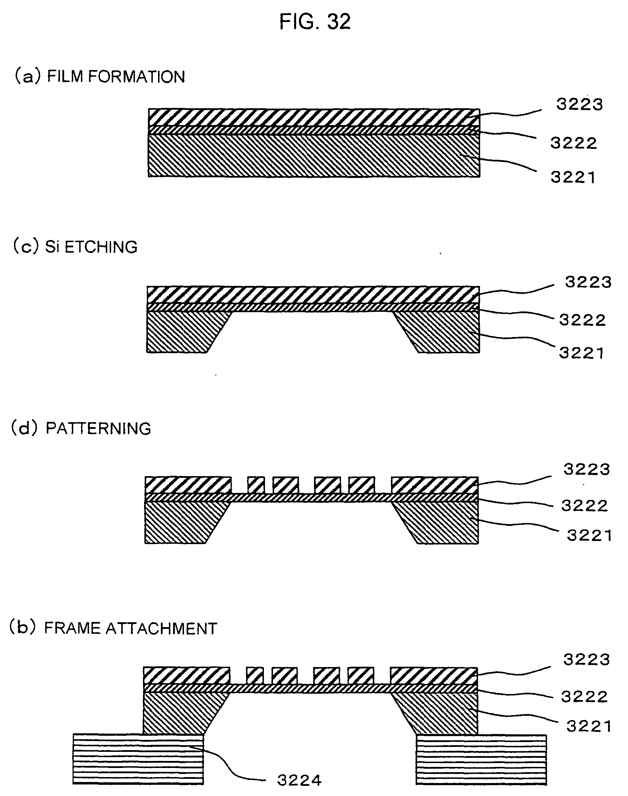

Herein, referring to Fig. 32, the writing sequence of the master mask 2703 will be described in detail. At first, as shown in Fig. 32, (a), a SiC membrane 3222 is formed on a silicon wafer 3221 and an X-ray absorber 3223 is formed on the SiC membrane 3222. Then, as shown in Fig. 32, (b), the silicon substrate 3221 is etched from the back side so that the back side of the SiC membrane 3222 is exposed. Then, as shown in Fig. 32, (c), the X-ray absorber 3223 is patterned by the use of the pattern writing system 2705 shown in Fig. 27, (a).

When patterning the X-ray absorber 3223, a resist (not shown) is applied to the X-ray absorber 3223. In this state, the master mask 2703 is set in the pattern writing system 2705 shown in Fig. 27, (a) so that the master mask 2703 is pattern-exposed by the pattern writing system 2705. The master mask pattern-exposed as shown in Fig. 32, (c) is finally attached with a frame 3224 as shown in Fig. 32, (d).

As shown in Fig. 32, in this invention, the frame 3224 is attached to the master mask after the patterning. This differs from a conventional method where the frame 3224 is attached before the patterning. The reason for attaching the frame 3224 after the patterning in this invention as described above is that when writing by the pattern writing system 2705, a wafer stage for a general exposure system can be used, as it is, as the XY stage 2704 of the master mask writing system 2701 unless there is the frame 3224. From the same reason, the patterning shown in Fig. 32, (c) may be carried out before the silicon etching of Fig. 32, (b).

On the other hand, the mask repeater 2702 shown in Fig. 27, (b) is a system constituted on the basis of the 1:1 X-ray exposure system, wherein an objective mask 2706 is set on a vertical-type stage 2707 while the master mask 2703 is disposed at a position slightly spaced apart from the mask 2706, and an X-ray 2708 is irradiated so as to cover a pattern portion 2709a of the master mask 2703. Since the other portions of the mask repeater 2702 are the same as those of the general 1:1 X-ray exposure system, explanation thereof is omitted.

In this embodiment, the pattern portion 2709a in the master mask 2703 has a relatively small area of 32mm × 40mm. That is, considering that the writing area of the general quadruple mask has the size of 132mm × 104mm at maximum, it is 1/9 or less in terms of the area. Therefore, at least nine identical patterns of the pattern portion 2709a can be transferred and exposed onto the mask 2706 by step and repeat in a very short time (although depending on resist sensitivity, one pattern can be exposed in about one second) so that, as shown in Fig. 27, (c), nine pattern portions 2709b are formed on the mask 2706 in a short time.

On the other hand, in the case where, like conventional, the mask 2706 is directly written by the electron-beam mask writing system or the like, since the nine patterns 2709b are respectively written, a writing time becomes long.

Further, it is necessary to apply optical proximity correction (hereinafter abbreviated as OPC) to the 65nm generation mask. That is, it is necessary to form a pattern in consideration of rounding or the like caused by diffraction of light. Herein, the pattern in consideration of OPC is called an OPC pattern.

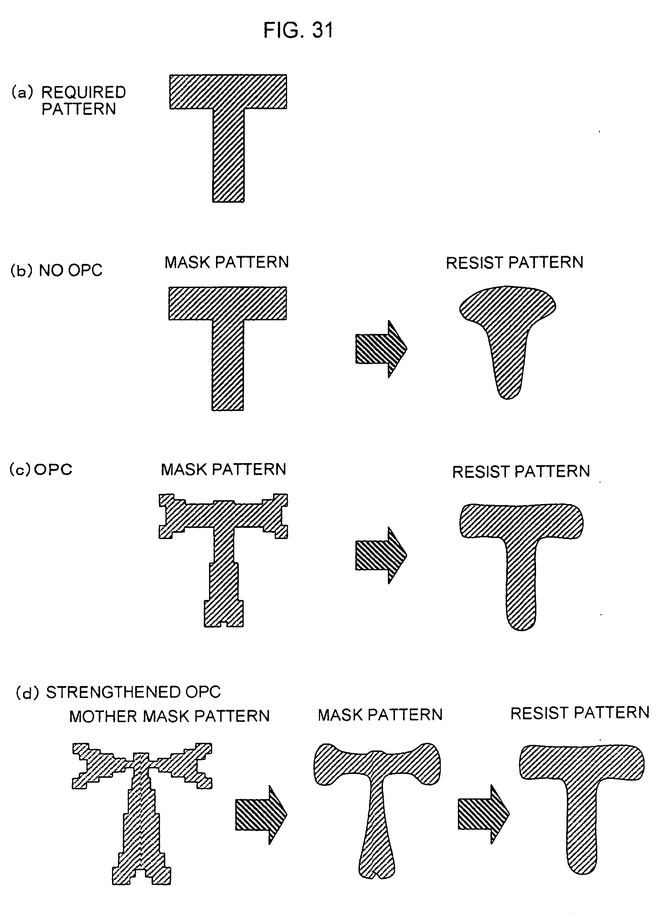

For example, in the case where a T-shaped pattern as shown in Fig. 31, (a) is formed as a pattern required for a semiconductor chip, when a mask not applied with OPC is used as shown in the figure, (b), nothing but a rounded T-shaped pattern can be obtained as a resist pattern (precisely a resist pattern formed through a development process after pattern exposure in an exposure system) as shown in Fig. 31, (b). Taking this into account, use is generally made of a mask having an OPC pattern as shown in Fig. 31, (c) so that it is possible to obtain a shape close to the T-shaped pattern. However, for obtaining the OPC pattern as shown in Fig. 31, (c) by the use of the conventional mask repeater, a master mask requires a pattern applied with more strengthened OPC as shown in Fig. 31, (d). Data of the pattern shown in Fig. 31, (d) is very large and further a long mask writing time is required. In Fig. 27, when the OPC mask is used, even the single pattern 2709b takes about 10 hours and thus 90 hours are required in total.

As clear also from the foregoing, a feature of this invention resides particularly in that a mask having a number of identical patterns can be written in a short time.

Further, differing from a mask repeater constituted on the basis of the conventional light exposure system, it is sufficient in this invention that the pattern of the pattern portion 2709a (Fig. 27, (b)) of the master mask 2703 be the same as that of the pattern portion 2709b of the objective mask 2706 and it is not necessary to use the more strengthened OPC pattern. The reason for this is that since the mask repeater 2702 uses the very short wavelength X-ray for pattern exposure of the mask 2706, it is possible to make very small the rate of the X-ray that is broadened due to diffraction while proceeding through a gap between the master mask 2703 and the mask 2706 and, as a result, the pattern-exposed pattern 2709b becomes substantially the same as the pattern 2709a. Therefore, the OPC for the master mask according to this invention may be the same as that of the normal OPC mask as shown in Fig. 31, (c) and thus the complicated OPC as shown in Fig. 31, (d) is unnecessary.

Now, referring to Fig. 28, description will be made about one example of the pattern writing system 2705 that is usable in the master mask writing system 2701 shown in Fig. 27. Fig. 28 is a structural diagram of the pattern writing system 2705. The pattern writing system 2705 uses a mirror device 2710 for pattern formation. The mirror device has micromirrors arranged as many as several hundred thousands to one million. Ultraviolet light L1 from a non-illustrated exposure light source is reflected by a mirror 2711 so that ultraviolet light L2 is irradiated onto the mirror device 2710. As a result, ultraviolet light L3 reflected by the mirror device 2710 and proceeding downward has a pattern. The ultraviolet light L3 passes through a projection optical system 2713 composed of lenses 2712a and 2712b. By this, the pattern of the surface of the mirror device 2710 is projected onto a microlens array 2714. Herein, the respective micromirrors in the mirror device 2710 are in one-to-one correspondence with respective microlenses in the microlens array 2714. A pinhole plate 2715 is disposed at positions where respective light beams are converged by the microlens array 2714. An image of this pinhole plate 2715 is projected onto the master mask 2703 through a reduction-projection optical system 2716. Thus, an aggregate of a large number of spots is projected onto the master mask 2703.

As the light source of the pattern writing system 2705 shown in Fig. 28 in this embodiment, a continuous light source is preferable in order to cope with the mirror device 2710 capable of ON/OFF operation at high speed. Therefore, as the light source, it is preferable to use, for example, the second harmonic of an argon ion laser. The reason therefor is that the argon ion laser is capable of oscillating at various wavelengths and has an oscillation line at a wavelength of 496nm. Therefore, this shows that continuous light with a wavelength of 248nm can be generated as the second harmonic wave. Since this wavelength is the same as that of the KrF excimer laser, an XY stage and a reduction-projection optical system for the KrF exposure system can be used, as they are, for the reduction-projection optical system 116 and the XY stage 2704 shown in Fig. 27.

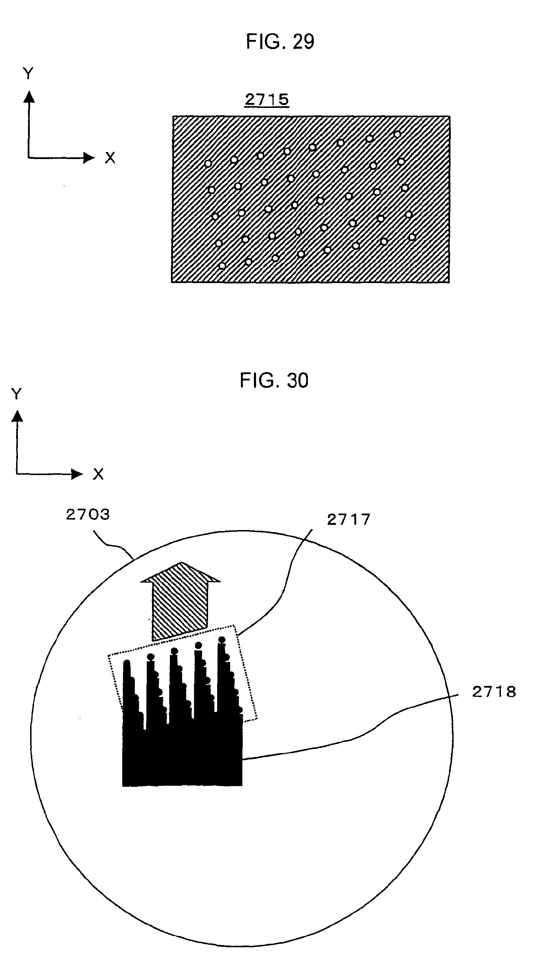

On the other hand, as shown in Fig. 29, the pinhole plate has a large number of pinholes arranged obliquely. As shown in Fig. 30, by scanning the master mask 103 in -Y-direction during exposure, an area 2717 where the pinhole plate 2715 is projected is scanned in Y-direction so that an exposed area 2718 is formed on the master mask 2703.

By using the mirror device 2710 in the master mask writing system 2701 like in this embodiment, the pattern writing speed becomes very high and therefore a writing time for the master mask 2703 can be shortened.

Further, since the master mask 2703 uses the silicon wafer 3221 (Fig. 32) as the substrate thereof as described before, a stage for the KrF exposure system or the ArF exposure system can be used, as it is, for the XY stage 2704 of the master mask writing system 2701 (Fig. 27, (a)). Also for the reduction-projection optical system 2716 of the pattern writing system 2705 shown in Fig. 28, lenses for the KrF exposure system or the ArF exposure system can be used as they are. Therefore, as described above, according to the mask writing system of this invention, it becomes easy to constitute the master mask writing system on the basis of the exposure system on the market.

Use is made of the 1:1 X-ray exposure system for the mask repeater of this invention. However, as will be described hereinbelow, use may also be made of a 1:1 electron-beam proximity exposure system called LEEPL (Low Energy E-Beam Proximity Lithography). The reason therefor is that since this system also does not use light for exposure but uses an electron beam, broadening due to diffraction is small and, therefore, when using a LEEPL mask as a master mask, more strengthened OPC is not required. Further, like in the case of the 1:1 X-ray exposure system, it is not necessary to stick a pellicle.

Further, as the light source of the pattern writing system 2705 shown in Fig. 28, two excimer lasers each adapted to operate at 5kHz may be alternately operated and obtained two beams may be overlapped, thereby coping with the mirror device 110 that operates at high speed at about 10kHz.

Further, in that event, another band-narrowing laser (called a seeder) may be used to lock the wavelength of the two excimer lasers. According to this, wavelength stabilization and wavelength band narrowing become unnecessary for those two excimer lasers.

When use is made, as the excimer lasers, of KrF excimer lasers with a wavelength of 248nm, use may be made, as the seeder, of a NeCu laser that is known to operate at a wavelength of 248.6nm. The NeCu laser is a kind of ion laser and is preferable in that band-narrowed laser light can be obtained without particularly using a wavelength band narrowing element and, further, since the laser transition occurs between defined energy levels of atoms, there is no change in center wavelength.

As described above, according to this invention, by the use of a master mask larger than an objective mask, the mask, particularly the next generation mask that cannot use a pellicle, can be written quickly and inexpensively without replacing the master mask. Further, since the large-size master mask has a larger minimum line width as compared with the objective mask, it can be written by the use of the conventional exposure system such as KrF or ArF and, further, since a soft pellicle can be used at such an exposure wavelength, there is no occurrence of the case where the mask cannot be used due to particles.

Further, since the master mask is large-sized, the objective mask can be written by one-time exposure and an exposure time is only several seconds per mask. Therefore, there is no occurrence of pattern abnormality after development. Further, since a mask writing time is shortened, even if the mask is frequently replaced in a throwaway manner, the number of semiconductor device manufacturing days does not largely increase. From the foregoing, in the lithography technology using pellicleless masks that are weak against particles, it becomes unnecessary to worry about particularly the particles.

### Industrial Applicability

According to this invention, by making a master mask larger than an actual mask for use in wafer exposure, there is obtained a mask repeater that can reduce the number of times of transfer and exposure in writing of the actual mask from the master mask and further reduce even the number of oblique exposure and stitch exposure, thereby enabling quick writing of the actual mask. Further, in this invention, it is possible to constitute a mask repeater that can write a next generation mask by using a soft X-ray and a reduction-projection optical system to reduce a pattern of a master mask. Moreover, in this invention, there is obtained a pattern writing system that can write a 1:1 mask being a next generation mask.

## Claims

1. A mask repeater for writing an actual mask from a master mask, wherein said master mask and said actual mask differ in size from each other.

2. A mask repeater according to claim 1, wherein said actual mask is a 1:1 mask for 1:1 exposure.

3. A mask repeater according to claim 1, wherein the size of said master mask is larger than that of said actual mask.

4. A mask repeater according to claim 3, wherein said actual mask is a next generation mask for ultraviolet light of 190nm or less or an electron beam.

5. A mask repeater according to claim 4, wherein said master mask is provided with a pellicle.

6. A mask repeater according to claim 3, wherein said actual mask has a pattern transferred by applying a soft X-ray to said master mask.

7. A mask repeater according to claim 6, further a reduction-projection optical system for reduction-projecting said soft X-ray.

8. A mask repeater according to claim 7, wherein said actual mask is a mask that transfers a pattern by the use of an electron beam.

9. A mask repeater according to claim 3, wherein said master mask has a shape defined by a scan direction and a step direction perpendicular to said scan direction, said shape being longer in said scan direction than in said step direction.

10. A mask repeater for writing an actual mask from a master mask, said mask repeater comprising an exposure system specified by a scan exposure system which exposes said master mask to said actual mask;
the scan exposure system scanning said actual mask in a scan direction and/or a step direction and performing oblique exposure in said scan direction or said step direction without changing a shape of a slit-shaped irradiation area.

11. A mask repeater according to claim 10, further comprising:
control means for executing a control operation such that, said slit-shaped irradiation area is scanned over an exposure area on said mask in said scan direction and said oblique exposure in said scan direction is performed by stopping irradiation of said slit-shaped irradiation area when said slit-shaped irradiation area has reached each of both ends of said exposure area.

12. A mask repeater according to claim 10, wherein the control operation is performed by scanning in said step direction, said slit-shaped irradiation area having an elongated and oblique shape.

13. A mask repeater according to claim 12, further comprising a mechanism that moves said slit-shaped irradiation area not only in said scan direction but also in said step direction perpendicular to said scan direction and, after moving said slit-shaped irradiation area in said step direction, moves it back in said scan direction.

14. A mask repeater according to claim 13, wherein said master mask is larger in size than said actual mask.

15. A mask repeater according to claim 10, wherein said master mask and said actual mask are proximity masks, respectively.

16. A mask writing method for writing a next generation mask that is used in a semiconductor device exposure system using vacuum ultraviolet light having a wavelength of 190nm or less or an electron beam, comprising the step of:
preparing a photomask with a pellicle, that is larger than said mask, and a reduction-projection optical system; and
performing reduction-projection exposure of the photomask through the reduction-projection optical system to manufacture said next generation mask.

17. A mask writing system for writing a next generation mask for use in a semiconductor device exposure system using vacuum ultraviolet light having a wavelength of 190nm or less or an electron beam, said mask writing system comprising:
support means for movably supporting a photomask, with a pellicle, larger than said next generation mask and
a reduction-projection optical system for reduction-projection exposing said photomask, wherein said next generation mask is written by reduction-projection exposing said photomask.

18. A mask writing system according to claim 17, wherein said support means comprises a stage for placing thereon said photomask and said stage is movable in two directions perpendicular to each other.

19. A mask writing method according to claim 16, wherein said next generation mask is a proximity mask.

20. A mask writing system according to claim 17, wherein said next generation mask is a proximity mask.

21. An electron-beam mask writing method for writing an electron-beam mask for use in a semiconductor device exposure system using an electron beam, said electron-beam mask writing method comprising the steps of:
irradiating an X-ray onto an X-ray mask larger than said mask and
guiding the X-ray from said X-ray mask to a mask substrate at least by reduction projection.

22. A mask writing system for writing an electron-beam mask for use in a semiconductor device exposure system using an electron beam, said mask writing system comprising:
support means for movably supporting an X-ray mask larger than said electron-beam mask and
a reduction-projection optical system for reduction-projection exposing said X-ray mask,
wherein said electron-beam mask is written by reduction-projection exposing said X-ray mask.

23. A mask writing system according to claim 22, further comprising:
cover means for covering said X-ray mask larger than said electron-beam mask,
wherein said cover means comprises an open/close shutter and a cavity having a structure for injecting a gas.

24. A mask writing method for writing a mask which has a predetermined size and that is used in exposure using ultraviolet light of a predetermined or less wavelength or an electron beam, said mask writing method comprising the steps of:
preparing a master mask having a size larger than that of said mask to be manufactured and
carrying out reduction-projection exposure of said master mask by the use of a reduction-projection optical system to manufacture said mask.

25. A mask writing method according to claim 24, wherein a pellicle is attached to said master mask in said reduction-projection exposure.

26. A mask writing method according to claim 24, wherein said master mask and said mask are in a one-to-one relationship during the reduction-projection exposure of said master mask.

27. An exposure method for transferring a pattern of a first mask onto a first substrate by the use of a soft X-ray as an exposure light source and a reduction-projection optical system to thereby write a second mask;
placing said second mask in proximity to a second substrate; and
irradiating a hard X-ray or an electron beam onto said second mask to form a pattern on said second substrate.

28. A mask writing method for writing a semiconductor device manufacturing mask by reduction X-ray exposure that transfers a pattern of a first mask onto a first substrate by the use of a soft X-ray as an exposure light source and a reduction-projection optical system.

29. A mask writing system comprising a soft X-ray source and a reduction-projection optical system composed of reflecting mirrors, wherein an X-ray from said X-ray source is irradiated onto a first mask having a pattern and is reduction-projected onto a mask substrate of a second mask through said reduction-projection optical to transfer the pattern of the first mask to the mask substrate of the second mask.

30. A mask written by the use of a soft X-ray having a predetermined wavelength.

31. A mask writing method comprising the steps of:
preparing a master mask including a pattern with a predetermined line width and
transferring a pattern of said master mask by the use of a soft X-ray and a reduction-projection optical system, to write a mask with a pattern having a line width narrower than said predetermined line width.

32. A semiconductor device manufacturing method comprising the steps of:
preparing a master mask including a pattern with a predetermined line width;
transferring a pattern of said master mask by the use of a soft X-ray and a reduction-projection optical system, to write a mask with a pattern having a line width narrower than said predetermined line width; and
exposing and transferring said mask to manufacture a semiconductor device.

33. A semiconductor device manufacturing method according to claim 32, wherein transfer of said mask is performed by an electron beam which differs from the soft X-ray used in transferring the pattern of said master mask.

34. A mask writing method for writing, from a plurality of first masks, a single second mask by reduction projection, said mask writing method comprising the steps of:
controlling irradiation of exposure light so that the exposure light is irradiated to a slit-shaped area with a fixed width on a substrate of said second mask while a corresponding one of said first masks and the substrate of said second mask are synchronously moved, and said exposure light is irradiated only while the whole of said slit-shaped area is located within a pattern transfer area on the substrate of said second mask.

35. A mask writing method for writing, from a plurality of first masks, a single second mask by reduction projection, comprising the steps of:
simultaneously moving each of the first masks and a mask substrate of the second mask and
irradiating exposure light on the mask substrate of the second mask in a slit shape which has a fixed width, so that two adjacent patterns of the first masks are partially overlapped with each other on the mask substrate of the second mask with the fixed width.

36. A mask writing method for writing, from a plurality of first masks, a single second mask by reduction projection, said mask writing method comprising the steps of:
irradiating exposure light onto a substrate for said second mask while a corresponding one of said first masks and said substrate are synchronously moved;
wherein said exposure light passes through at least two plates each having an opening, said two plates comprising a first plate having a slit-shaped opening and a second plate having a rectangular opening with at least a pair of parallel sides.

37. A mask writing system for writing, from a plurality of first masks, a single second mask by reduction projection and by stitch exposure, comprising:
a slit plate having an opening with a fixed width for forming an irradiation area having a width substantially equal to a width of said stitch exposure on a substrate for said second mask, and
moving means for moving said irradiation area within a pattern transfer area of said substrate.

38. A mask writing system according to claim 37, wherein said moving means moves said substrate in a predetermined direction and said opening with the fixed width of said slit plate extends in a direction perpendicular to the moving direction of said second mask.

39. A mask writing system according to claim 37, wherein said opening of said slit plate has a trapezoidal shape.

40. A mask writing system according to claim 37, wherein said opening of said slit plate has a rhombic shape.

41. A mask writing method for writing, from a plurality of first masks, a single second mask by reduction projection and by stitch exposure, said mask writing method comprising the steps of:
scanning in a slit shape with a predetermined width over the whole area of a corresponding one of said first masks for said stitch exposure;
sequentially irradiating a corresponding slit-shaped irradiation area onto a substrate for said second mask; and
starting irradiation from an end portion of said first mask and finishing the irradiation at an end portion on the opposite side, wherein a width of said slit-shaped irradiation area is substantially constant during scanning.

42. A pattern writing system for writing a mask by performing pattern writing on a master mask larger than said mask and then reduction-projecting said master mask, comprising at least one of the followings:
a scan exposure mechanism that is provided as a stage for a master mask and that has a stroke long in a scan direction;
a reduction-projection optical system for an exposure system;
a lubricating oil circulation system for micromirrors;
a cooling mechanism for a pinhole plate; and
a mechanism for performing pattern writing while causing overlapping in two directions perpendicular to each other.

43. A mask repeater for writing a mask by performing pattern writing on a master mask larger than said mask and then reduction-projecting said master mask, comprising:
a scan exposure mechanism as said mask repeater, wherein a mask stage for a master mask in said scan exposure mechanism has a stroke in a scan direction that is long enough to make stitch exposure unnecessary.

44. A mask repeater according to claim 43, wherein said stroke in the scan direction is longer than 132mm.

45. A master mask having a scan direction and a step direction perpendicular to said scan direction and used for forming a mask through reduction exposure, said master mask having a length in said scan direction that makes stitch exposure unnecessary.

46. A pattern writing system comprising a laser light generating portion and two-dimensionally arranged micromirrors, wherein said two-dimensionally arranged micromirrors are attached with a circulation system adapted to move a gas contacting said mirrors and a tank containing a lubricating oil is connected in said circulation system.

47. A pattern writing system according to claim 46, wherein the lubricating oil is a fluorine-based polymer.

48. A pattern writing system comprising a laser light generating portion, two-dimensionally arranged micromirrors, a microlens array, a pinhole plate that can divide irradiated laser light into a large number of thin light beams, and a structure for forcibly cooling said pinhole plate.

49. A pinhole plate for a pattern writing system, manufactured by forming a metal film on a surface of a quartz glass and exposing a resist applied to said metal film, in the shape of holes by the use of an electron-beam exposure system to thereby form holes in said metal film.

50. A gray-scale method using a pulse laser light generating portion and two-dimensionally arranged micromirrors and carrying out pattern writing that reduction-projects said micromirrors onto a substrate, comprising the step of:
carrying out pattern writing by partially overlapping, on said substrate, projection patterns of said two-dimensionally arranged micromirrors, along both of two moving directions perpendicular to each other.

51. A pattern writing system comprising two-dimensionally arranged micromirrors, a microlens array, and a reduction-projection optical system,
wherein said reduction-projection optical system is a reduction-projection optical system for an optical exposure system.

52. A mask exposure method that, in order to write a mask for use in semiconductor device manufacturing, exposes a predetermined pattern onto a substrate of said mask through a reduction-projection exposure from a master mask larger than said mask by the use of a reduction-projection optical system, comprising the steps of:
writing a single mask by the use of a plurality of master masks;
scanning a corresponding one of said plurality of master masks and said mask in mutually opposite directions; and
moving the corresponding one of said master masks also in a direction perpendicular to said scan direction and scanning said master mask also in directions parallel to and opposite to said scan direction.

53. A mask exposure method according to claim 52, comprising the steps of:
performing the pattern exposure onto said mask by scanning forward and backward the corresponding one of said master masks.

54. A master mask for use in the mask exposure method according to claim 52.

55. A mask repeater for writing a mask for use in semiconductor device manufacturing by exposing a predetermined pattern onto a substrate of said mask through a reduction-projection exposure from a master mask larger than said mask by the use of a reduction-projection optical system, comprising:
a mechanism for writing a single mask by the use of a plurality of master masks to perform pattern exposure by scanning a corresponding one of said plurality of master masks and said mask in mutually opposite directions and by moving the corresponding one of said master masks also in a direction perpendicular to said scan direction and scanning said master mask also in directions parallel to and opposite to said scan direction.

56. A mask repeater according to claim 55, wherein the pattern exposure onto said mask is performed by scanning forward and backward the corresponding one of said master masks.

57. A mask writing method wherein a mask of a semiconductor device exposure system is used to perform pattern writing by 1:1 exposure.

58. A mask writing method according to claim 57, comprising the steps of:
forming a plurality of patterns on said mask and
repeating the 1:1 exposure of the pattern writing of said mask.

59. A mask writing method according to claim 57, further comprising the step of:
writing a master mask for a 1:1 X-ray exposure system or a 1:1 electron-beam exposure system for use in mask writing, by the use of a pattern writing system using a mirror device.

60. A mask writing method according to claim 57, wherein said mask of the semiconductor device exposure system is a mask for SOC.

61. A mask writing method for writing a mask for semiconductor wafer writing, comprising the steps of:
writing a master mask for writing of said mask and
forming a pattern of said master mask on said mask through 1:1 exposure.

62. A mask writing method according to claim 61, wherein said 1:1 exposure is carried out by the use of either of a 1:1 X-ray exposure system and a 1:1 electron-beam exposure system.

63. A mask writing method according to claim 61, wherein a pattern writing system having a mirror device is used for writing said master mask.

64. A mask writing system for writing a mask for semiconductor wafer writing, said mask writing system comprising:
a master mask writing system for writing a master mask having a pattern to be written on said mask and
a mask writing system for forming the pattern of said master mask on said mask through 1:1 exposure.

65. A mask writing system according to claim 64, wherein said master mask writing system writes the master mask having a single pattern portion and said mask writing system is constituted by a mask repeater that repeatedly writes the single pattern portion of said master mask on said mask through the 1:1 exposure.

66. A mask writing system according to claim 65, wherein said mask repeater is constituted by either of a 1:1 X-ray exposure system and a 1:1 electron-beam exposure system.

67. A mask writing system according to claim 64, wherein said master mask writing system is constituted by a pattern writing system comprising a mirror device.

68. A semiconductor wafer writing mask written by said 1:1 exposure according to claim 64.

69. A semiconductor wafer writing mask according to claim 68, including a plurality of identical patterns.
